# EUROPEAN PATENT APPLICATION

(11) **EP 1 903 623 A2**
(43) Date of publication of application: **26.03.2008**
(21) Application number: 07018079.9
(22) Date of filing: 14.09.2007
(51) Int. Cl.: H01L 43/08, H01L 43/12

(54) **Tunnel type magnetic sensor having fixed magnetic layer of composite structure containing CoFeB film and method for manufacturing the same**

(30) Priority: 21.09.2006 JP 2006255646; 14.03.2007 JP 2007065657
(71) Applicant: ALPS ELECTRIC CO., LTD., Tokyo 145-8501 (JP)
(72) Inventor: Ikarashi, Kazuaki, Tokyo 145-8501 (JP); Umetsu, Eiji, Tokyo 145-8501 (JP); Tanaka, Kenichi, Tokyo 145-8501 (JP); Asatsuma, Kota, Tokyo 145-8501 (JP)
(74) Representative: Klunker . Schmitt-Nilson . Hirsch

(57) **Abstract**

A fixed magnetic layer (4) has a laminated structure composed of a first fixed magnetic layer (4a), an interface layer (4b) of CoFe or Co, and a second fixed magnetic layer (4c) formed of CoFeB provided in that order from the bottom. An insulating barrier layer (5) composed of Al-O is formed on the second fixed magnetic layer. When a lamination structure composed of CoFeB/CoFe/Al-O is formed as described above, a low RA and a high rate of change in resistance (ΔR/R) can be simultaneously obtained. In addition, variations in RA and rate of change in resistance (ΔR/R) can be suppressed as compared to that in the past.

## Description

### CLAIM OF PRIORITY

This application claims benefit of the unexamined Japanese Patent Applications No. 2006-255646 filed on Sept. 21, 2006, and No. 2007-065657 filed on March 14, 2007, which are hereby incorporated by reference.

### BACKGROUND OF THE INVENTION

### 1. Field of the Invention

The present invention relates to tunnel type magnetic sensors which are, for example, mounted in hard disc apparatuses or used as magnetoresistive random access memories (MRAM), and more particularly, relates to a tunnel type magnetic sensor in which when Al-O is used for an insulating barrier layer, a low RA and a high rate of change in resistance (ΔR/R) can be simultaneously obtained and variations in properties can also be suppressed, and to a method for manufacturing the same.

### 2. Description of the Related Art

A tunnel type magnetic sensor is a sensor which generates the change in resistance using a tunnel effect, in which when the magnetization of a fixed magnetic layer and that of a free magnetic layer are antiparallel to each other, since a tunnel current is unlikely to flow via an insulating barrier layer (tunnel barrier layer) provided between the fixed magnetic layer and the free magnetic layer, the resistance is increased to a maximum value, and in which, on the other hand, when the magnetization of the fixed magnetic layer and that of the free magnetic layer are parallel to each other, since the tunnel current is most likely to flow, the resistance is decreased to a minimum value.

By using the principle described above, when the magnetization of the free magnetic layer varies by influence of an external magnetic field, this variation in electrical resistance is grasped as the change in voltage, and as a result, a leak magnetic field from a recording medium can be detected.

When a material for the insulating barrier layer is changed, since the properties represented by the rate of change in resistance (ΔR/R) is changed, the properties must be examined for each material used for the insulating barrier layer.

As important properties of the tunnel type magnetic sensor, for example, the rate of change in resistance (ΔR/R) and RA (element resistance R × area A) may be mentioned, and in order to optimize the properties mentioned above, improvement in materials for the fixed magnetic layer, the free magnetic layer, and the insulating barrier layer provided therebetween, and improvement in film configuration thereof have been carried out. The related arts have been disclosed in Japanese Unexamined Patent Application Publications Nos. 2004-23015, 2006-165059, 2006-165265, and 2005-197764.

In the above Japanese Unexamined Patent Application Publications, aluminum oxide (Al-O) is used for the insulating barrier layer. In a tunnel type magnetic sensor having a lamination structure composed of an antiferromagnetic layer, a fixed magnetic layer, an insulating barrier layer, and a free magnetic layer, when the insulating barrier layer is formed of Al-O, and the fixed magnetic layer (in the case of a laminated ferrimagnetic structure, a second fixed magnetic layer in contact with the insulating barrier layer) is formed of a single CoFeB layer, there has been a problem in that a low RA and a high rate of change in resistance (ΔR/R) are difficult to be simultaneously obtained. When the rate of change in resistance (ΔR/R) increases, the RA also increases, and on the other hand, when the RA decreases, the rate of change in resistance (ΔR/R) also decreases. In addition, when a single CoFeB layer structure is employed, a high rate of change in resistance (ΔR/R) could not be intrinsically obtained.

As described in Fig. 4 of Japanese Unexamined Patent Application Publication No. 2004-23015, paragraph [0036] of Japanese Unexamined Patent Application Publication No. 2006-165059, and paragraph [0054] of Japanese Unexamined Patent Application Publication No. 2006-165265, the fixed magnetic layer (or the second fixed magnetic layer) is formed of CoFe/CoFeB, and a CoFeB layer formed of CoFeB is in contact with the insulating barrier layer; however, according to the structure described above, a low RA and a high rate of change in resistance (ΔR/R) could not be simultaneously obtained.

In addition, for example, in paragraph [0084] of Japanese Unexamined Patent Application Publication No. 2005-197764, materials for the fixed magnetic layer has been disclosed; however, a material and a layer structure, which simultaneously give a low RA and a high rate of change in resistance (ΔR/R), have not been disclosed.

### SUMMARY OF THE INVENTION

Accordingly, the present invention has been conceived to solve the above problems in the related art and relates to a tunnel type magnetic sensor in which an insulating barrier layer is formed of A1-O. In particular, the present invention provides a tunnel type magnetic sensor, which can simultaneously obtain a low RA and a high rate of change in resistance (ΔR/R) and which can suppress variations in the properties, and a method for manufacturing the above tunnel type magnetic sensor.

A tunnel type magnetic sensor according to a first aspect of the present invention, comprises: a lamination portion including a fixed magnetic layer in which a magnetization direction thereof is fixed; an insulating barrier layer; and a free magnetic layer in which a magnetization direction thereof is variable with respect to an external magnetic field, which are laminated to each other in that order from the bottom. In the tunnel type magnetic sensor described above, the insulating barrier layer is formed of Al-O, and a barrier layer-side magnetic layer which forms at least a part of the fixed magnetic layer and which is in contact with the insulating barrier layer is formed to have a CoFeB region formed of CoFeB and an intervening region which is located between the CoFeB region and the insulating barrier layer and which is formed of CoFe or Co.

According to the present invention, the CoFeB region preferably has a composition gradient region in which a B concentration gradually decreases from an opposite side opposite to a boundary with the intervening region toward the intervening region.

A tunnel type magnetic sensor according to a second aspect of the present invention comprises: a lamination portion including a fixed magnetic layer in which a magnetization direction thereof is fixed; an insulating barrier layer; and a free magnetic layer in which a magnetization direction thereof is variable with respect to an external magnetic field, which are laminated to each other in that order from the bottom. In the tunnel type magnetic sensor described above, the insulating barrier layer is formed of Al-O, a barrier layer-side magnetic layer which forms at least a part of the fixed magnetic layer and which is in contact with the insulating barrier layer is formed of CoFeB, and in the barrier layer-side magnetic layer, a B concentration at an interface side in contact with the insulating barrier layer is lower than that at an opposite side opposite to the interface side.

According to the present invention, the barrier layer-side magnetic layer preferably has a composition gradient region in which the B concentration gradually decreases from the opposite side toward the interface side.

According to the present invention, the barrier layer-side magnetic layer is preferably formed by element diffusion which occurs at an interface between a CoFeB layer formed of CoFeB and an interface layer which is located between the CoFeB layer and the insulating barrier layer and which is formed of CoFe or Co, the CoFeB layer and the interface layer being laminated to each other to form a lamination structure.

A tunnel type magnetic sensor according to a third aspect of the present invention, comprises: a lamination portion including a fixed magnetic layer in which a magnetization direction thereof is fixed; an insulating barrier layer; and a free magnetic layer in which a magnetization direction thereof is variable with respect to an external magnetic field, which are laminated to each other in that order from the bottom. In the tunnel type magnetic sensor described above, the insulating barrier layer is formed of Al-O, and a barrier layer-side magnetic layer which forms at least a part of the fixed magnetic layer and which is in contact with the insulating barrier layer is formed to have a lamination structure including a CoFeB layer formed of CoFeB and an interface layer which is located between the CoFeB layer and the insulating barrier layer and which is formed of CoFe or Co.

In any of the above tunnel type magnetic sensors according to the present invention, the barrier layer-side magnetic layer is formed of Co, Fe, and B, and the B concentration of the barrier layer-side magnetic layer is lower at the interface side with the insulating barrier layer than that at the opposite side opposite to the interface, or the B concentration at the interface side is 0 atomic percent, that is, the interface side is a CoFe region. The structure of the present invention is opposite to the structure described in Japanese Unexamined Patent Application Publications Nos. 2004-23015, 2006-165059, and 2006-165265. In addition, according to the present invention, as shown in experiments which will be described below, compared to a related example in which the barrier layer-side magnetic layer is formed of a single CoFeB layer, and a reference example in which the barrier layer-side magnetic layer is formed to have a lamination structure including CoFe and CoFeB laminated in that order from the bottom so that the CoFeB is in contact with the insulating barrier layer, a low RA (element resistance R × element area A) and a high rate of change in resistance (ΔR/R) can be simultaneously obtained. In addition, the variations in properties can also be suppressed as compared to that in the past.

According to the present invention, it is preferable that the CoFeB layer be formed of {CO_{y}Fe_{1-y}}₁₀₀₋ₓBₓ (where y indicates an atomic ratio), and that a B concentration x be in the range of more than 16 to 40 atomic percent.

In addition, in the present invention, the B concentration x is preferably in the range of 17.5 to 35 atomic percent.

Through the experiments which will be described later, it was found that the RA and the rate of change in resistance (ΔR/R) are changed by the variation in B concentration x. According to the present invention, in order to decrease the RA, increase the rate of change in resistance (ΔR/R), and suppress the variations in properties, the B concentration x is controlled in the range as described above.

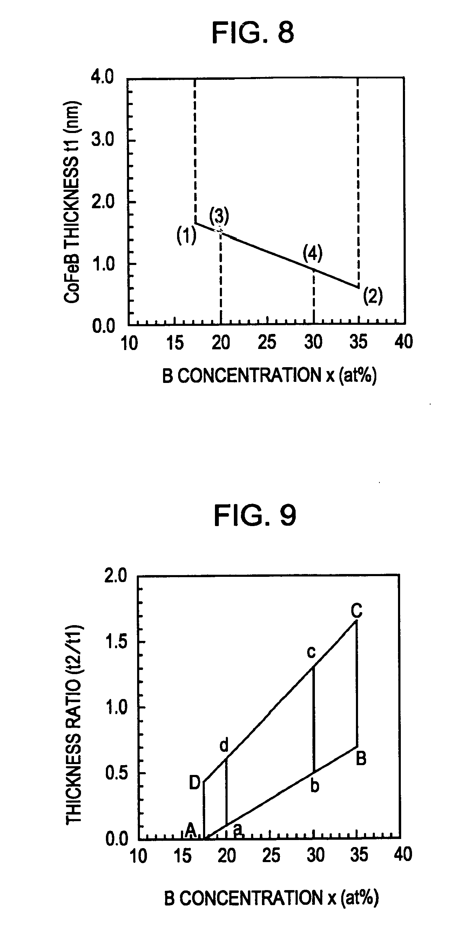

In addition, according to the present invention, the average thickness of the CoFeB layer is preferably in the range of a line (including the line) and thereabove in a graph shown in Fig. 8, the line that runs on point (1) (B concentration x: average thickness of the CoFeB layer)=(17.5 atomic percent: 1.65 nm) and on point (2) (B concentration x: average thickness of the CoFeB layer)=(35 atomic percent: 0.60 nm), and in a graph shown in Fig. 9, the thickness ratio of the interface layer to the CoFeB layer (average thickness of the interface layer/average thickness of the CoFeB layer) is preferably in the range surrounded by a line that runs on point A (B concentration x: thickness ratio)=(17.5 atomic percent: 0.00) and on point B (B concentration x: thickness ratio)=(35 atomic percent: 0.70) (including the line, however the point A is excluded), a line that runs on the point B and point C (B concentration x: thickness ratio)=(35 atomic percent: 1.65) (including the line), a line that runs on the point C and point D (B concentration x: thickness ratio)=(17.5 atomic percent: 0.43) (including the line), and a line that runs on the point D and the point A (including the line, however the point A is excluded). As a result, a low RA and a high rate of change in resistance (ΔR/R) can be effectively obtained at the same time.

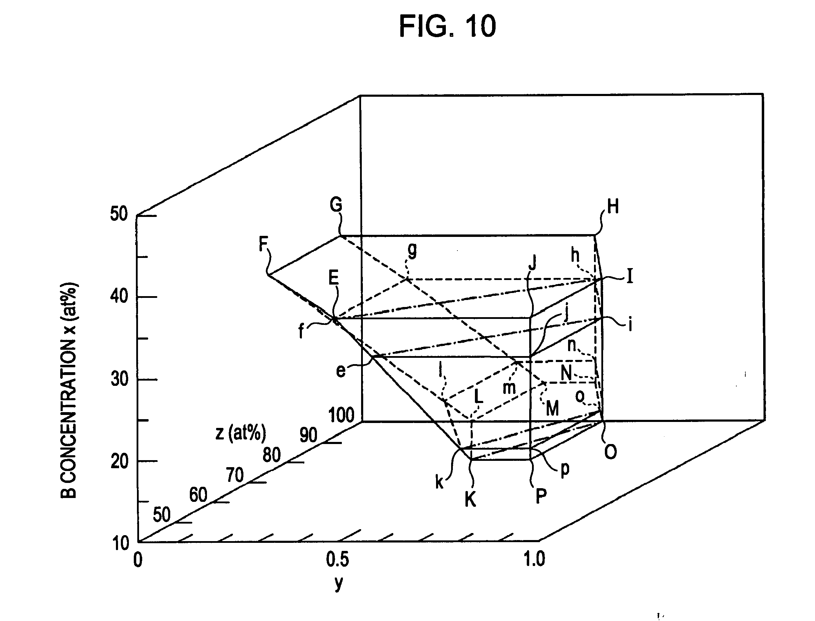

In addition, according to the present invention, the interface layer is preferably formed of Co_{z}Fe_{100-z}, and the atomic ratio y of the CoFeB layer and a Co concentration z of the interface layer are preferably defined within a polyhedron in a three-dimensional graph shown in Fig. 10 surrounded by:
a line (including the line) that runs on point E (atomic ratio y: Co concentration z: B concentration x)=(0.4: 50 atomic percent: 35 atomic percent) and point F (atomic ratio y: Co concentration z: B concentration x)=(0.05: 70 atomic percent: 35 atomic percent), a line (including the line) that runs on the point F and point G (atomic ratio y: Co concentration z: B concentration x)=(0.05: 90 atomic percent: 35 atomic percent), a line (including the line) that runs on the point G and point H (atomic ratio y: Co concentration z: B concentration x)=(0.7: 90 atomic percent: 35 atomic percent), a line (including the line) that runs on the point H and point I (atomic ratio y: Co concentration z: B concentration x)=(0.9: 70 atomic percent: 35 atomic percent), a line (including the line) that runs on the point I and point J (atomic ratio y: Co concentration z: B concentration x)=(0.9: 50 atomic percent: 35 atomic percent), and a line (including the line) that runs on the point J and the point E;
a line (including the line) that runs on point K (atomic ratio y: Co concentration z: B concentration x)=(0.75: 50 atomic percent: 17.5 atomic percent) and point L (atomic ratio y: Co concentration z: B concentration x)=(0.58: 70 atomic percent: 17.5 atomic percent), a line (including the line) that runs on the point L and point M (atomic ratio y: Co concentration z: B concentration x)=(0.58: 90 atomic percent: 17.5 atomic percent), a line (including the line) that runs on the point M and point N (atomic ratio y: Co concentration z: B concentration x)=(0.7: 90 atomic percent: 17.5 atomic percent), a line (including the line) that runs on the point N and point O (atomic ratio y: Co concentration z: B concentration x)=(0.9: 70 atomic percent: 17.5 atomic percent), a line (including the line) that runs on the point O and point P (atomic ratio y: Co concentration z: B concentration x)=(0.9: 50 atomic percent: 17.5 atomic percent), and a line (including the line) that runs on the point P and the point K; and
a line (including the line) that runs on the point E and the point K, a line (including the line) that runs on the point F and the point L, a line (including the line) that runs on the point G and the point M, a line (including the line) that runs on the point H and the point N, a line (including the line) that runs on the point I and the point O, and a line (including the line) that runs on the point J and the point P. Accordingly, a low RA and a high rate of change in resistance (ΔR/R) can be effectively obtained at the same time, and furthermore, the variations in properties can be suppressed.

In addition, according to the present invention, the B concentration x is preferably in the range of 20 to 30 atomic percent.

In this case, the average thickness of the CoFeB layer is preferably in the range of a line (including the line) and thereabove in the graph shown in Fig. 8, the line that runs on point (3) (B concentration x: average thickness of the CoFeB layer)=(20 atomic percent: 1.5 nm) and point (4) (B concentration x: average thickness of the CoFeB layer)=(30 atomic percent: 0.90 nm), and in the graph shown in Fig. 9, the thickness ratio of the interface layer to the CoFeB layer (average thickness of the interface layer/average thickness of the CoFeB layer) is preferably in the range surrounded by a line (including the line) that runs on point a (B concentration x: thickness ratio)=(20.0 atomic percent: 0.10) and point b (B concentration x: thickness ratio)=(30 atomic percent: 0.50), a line (including the line) that runs on the point b and point c (B concentration x: thickness ratio)=(30 atomic percent: 1.30), a line (including the line) that runs on the point c and point d (B concentration x: thickness ratio)=(20 atomic percent: 0.60), and a line (including the line) that runs on the point d and the point a.

In addition, the interface layer is preferably formed of Co_{z}Fe_{100-z}, and the atomic ratio y of the CoFeB layer and the Co concentration z of the interface layer are preferably defined within a polyhedron in the three-dimensional graph shown in Fig. 10 surrounded by:
a line (including the line) that runs on point e (atomic ratio y: Co concentration z: B concentration x)=(0.5: 50 atomic percent: 30 atomic percent) and point f (atomic ratio y: Co concentration z: B concentration x)=(0.20: 70 atomic percent: 30 atomic percent), a line (including the line) that runs on the point f and point g (atomic ratio y: Co concentration z: B concentration x)=(0.20: 90 atomic percent: 30 atomic percent), a line (including the line) that runs on the point g and point h (atomic ratio y: Co concentration z: B concentration x)=(0.7: 90 atomic percent: 30 atomic percent), a line (including the line) that runs on the point h and point i (atomic ratio y: Co concentration z: B concentration x)=(0.9: 70 atomic percent: 30 atomic percent), a line (including the line) that runs on the point i and point j (atomic ratio y: Co concentration z: B concentration x)=(0.9: 50 atomic percent: 30 atomic percent), and a line (including the line) that runs on the point j and the point e;
a line (including the line) that runs on point k (atomic ratio y: Co concentration z: B concentration x)=(0.70: 50 atomic percent: 20 atomic percent) and point 1 (atomic ratio y: Co concentration z: B concentration x)=(0.50: 70 atomic percent: 20 atomic percent), a line (including the line) that runs on the point 1 and point m (atomic ratio y: Co concentration z: B concentration x)=(0.50: 90 atomic percent: 20 atomic percent), a line (including the line) that runs on the point m and point n (atomic ratio y: Co concentration z: B concentration x)=(0.7: 90 atomic percent: 20 atomic percent), a line (including the line) that runs on the point n and point o (atomic ratio y: Co concentration z: B concentration x)=(0.9: 70 atomic percent: 20 atomic percent), a line (including the line) that runs on the point o and point p (atomic ratio y: Co concentration z: B concentration x)=(0.9: 50 atomic percent: 20 atomic percent), and a line (including the line) that runs on the point p and the point k; and
a line (including the line) that runs on the point e and the point K, a line (including the line) that runs on the point f and the point 1, a line (including the line) that runs on the point g and the point m, a line (including the line) that runs on the point h and the point n, a line (including the line) that runs on the point i and the point o, and a line (including the line) that runs on the point j and the point p.

Accordingly, a low RA and a high rate of change in resistance (ΔR/R) can be effectively obtained at the same time, and furthermore, the variations in properties can be suppressed.

According to the present invention, it is preferable that the fixed magnetic layer be a laminated ferrimagnetic structure formed of a first fixed magnetic layer, a second fixed magnetic layer, and a non-magnetic interlayer provided therebetween, and that the second fixed magnetic layer be the barrier layer-side magnetic layer in contact with the insulating barrier layer.

In accordance with a fourth aspect of the present invention, there is provided a method for manufacturing a tunnel type magnetic sensor having a lamination portion including a fixed magnetic layer in which a magnetization direction thereof is fixed, an insulating barrier layer, and a free magnetic layer in which a magnetization direction thereof is variable with respect to an external magnetic field, which are laminated to each other in that order from the bottom, comprising:
a step (a) of laminating an interface layer composed of CoFe or Co on a CoFeB layer composed of CoFeB to form a barrier layer-side magnetic layer which forms at least a part of the fixed magnetic layer;
a step (b) of forming the insulating barrier layer composed of Al-O on the barrier layer-side magnetic layer; and
a step (c) of forming the free magnetic layer on the insulating barrier layer.

According to the present invention, by the manufacturing method described above, a tunnel type magnetic sensor capable of simultaneously obtaining a low RA and a high rate of change in resistance (ΔR/R) can be easily and appropriately manufactured.

According to the present invention, the CoFeB layer is preferably formed of (Co_{y}Fe_{1-y}}₁₀₀₋ₓBₓ (where y indicates an atomic ratio), and a B concentration x is preferably set in the range of more than 16 to 40 atomic percent.

In addition, according to the present invention, the B concentration x is more preferably set in the range of 17.5 to 35 atomic percent.

In the case described above, the average thickness of the CoFeB layer is preferably formed in the range of a line (including the line) and thereabove in a graph shown in Fig. 8, the line that runs on point (1) (B concentration x: average thickness of the CoFeB layer)=(17.5 atomic percent: 1.65 nm) and point (2) (B concentration x: average thickness of the CoFeB layer)=(35 atomic percent: 0.60 nm), and in a graph shown in Fig. 9, the thickness ratio of the interface layer to the CoFeB layer (average thickness of the interface layer/average thickness of the CoFeB layer) is preferably adjusted in the range surrounded by a line that runs on point A (B concentration x: thickness ratio)=(17.5 atomic percent: 0.00) and point B (B concentration x: thickness ratio)=(35 atomic percent: 0.70) (including the line, however the point A is excluded), a line that runs on the point B and point C (B concentration x: thickness ratio)=(35 atomic percent: 1.65) (including the line), a line that runs on the point C and point D (B concentration x: thickness ratio)=(17.5 atomic percent: 0.43) (including the line), and a line that runs on the point D and the point A (including the line, however the point A is excluded).

In addition, the interface layer is preferably formed of Co_{z}Fe_{100-z}, and the atomic ratio y of the CoFeB layer and a Co concentration z of the interface layer are preferably adjusted within a polyhedron in a three-dimensional graph shown in Fig. 10 surrounded by:
a line (including the line) that runs on point E (atomic ratio y: Co concentration z: B concentration x)=(0.4: 50 atomic percent: 35 atomic percent) and point F (atomic ratio y: Co concentration z: B concentration x)=(0.05: 70 atomic percent: 35 atomic percent), a line (including the line) that runs on the point F and point G (atomic ratio y: Co concentration z: B concentration x)=(0.05: 90 atomic percent: 35 atomic percent), a line (including the line) that runs on the point G and point H (atomic ratio y: Co concentration z: B concentration x)=(0.7: 90 atomic percent: 35 atomic percent), a line (including the line) that runs on the point H and point I (atomic ratio y: Co concentration z: B concentration x)=(0.9: 70 atomic percent: 35 atomic percent), a line (including the line) that runs on the point I and point J (atomic ratio y: Co concentration z: B concentration x)=(0.9: 50 atomic percent: 35 atomic percent), and a line (including the line) that runs on the point J and the point E;
a line (including the line) that runs on point K (atomic ratio y: Co concentration z: B concentration x)=(0.75: 50 atomic percent: 17.5 atomic percent) and point L (atomic ratio y: Co concentration z: B concentration x)=(0.58: 70 atomic percent: 17.5 atomic percent), a line (including the line) that runs on the point L and point M (atomic ratio y: Co concentration z: B concentration x)=(0.58: 90 atomic percent: 17.5 atomic percent), a line (including the line) that runs on the point M and point N (atomic ratio y: Co concentration z: B concentration x)=(0.7: 90 atomic percent: 17.5 atomic percent), a line (including the line) that runs on the point N and point O (atomic ratio y: Co concentration z: B concentration x)=(0.9: 70 atomic percent: 17.5 atomic percent), a line (including the line) that runs on the point O and point P (atomic ratio y: Co concentration z: B concentration x)=(0.9: 50 atomic percent: 17.5 atomic percent), and a line (including the line) that runs on the point P and the point K; and
a line (including the line) that runs on the point E and the point K, a line (including the line) that runs on the point F and the point L, a line (including the line) that runs on the point G and the point M, a line (including the line) that runs on the point H and the point N a line (including the line) that runs on the point I and the point O, and a line (including the line) that runs on the point J and the point P.

Accordingly, a low RA and a high rate of change in resistance (ΔR/R) can be easily and effectively obtained at the same time, and furthermore, a tunnel type magnetic sensor capable of suppressing the variations in properties can be manufactured.

In addition, according to the present invention, the B concentration x is preferably set in the range of 20 to 30 atomic percent.

In the case described above, the average thickness of the CoFeB layer is preferably formed in the range of a line (including the line) and thereabove in the graph shown in Fig. 8, the line that runs on point (3) (B concentration x: average thickness of the CoFeB layer)=(20 atomic percent: 1.5 nm) and point (4) (B concentration x: average thickness of the CoFeB layer)=(30 atomic percent: 0.90 nm), and in the graph shown in Fig. 9, the thickness ratio of the interface layer to the CoFeB layer (average thickness of the interface layer/average thickness of the CoFeB layer) is preferably adjusted in the range surrounded by a line (including the line) that runs on point a (B concentration x: thickness ratio)=(20.0 atomic percent: 0.10) and point b (B concentration x: thickness ratio)=(30 atomic percent: 0.50), a line (including the line) that runs on the point b and point c (B concentration x: thickness ratio)=(30 atomic percent: 1.30), a line (including the line) that runs on the point c and.point d (B concentration x: thickness ratio)=(20 atomic percent: 0.60), and a line (including the line) that runs on the point d and the point a.

In addition, the interface layer is preferably formed of Co_{z}Fe_{100-z}, and the atomic ratio y of the CoFeB layer and the Co concentration z of the interface layer are preferably adjusted within a polyhedron in the three-dimensional graph shown in Fig. 10 surrounded by:
a line (including the line) that runs on point e (atomic ratio y: Co concentration z: B concentration x)=(0.5: 50 atomic percent: 30 atomic percent) and point f (atomic ratio y: Co concentration z: B concentration x)=(0.20: 70 atomic percent: 30 atomic percent), a line (including the line) that runs on the point f and point g (atomic ratio y: Co concentration z: B concentration x)=(0.20: 90 atomic percent: 30 atomic percent), a line (including the line) that runs on the point g and point h (atomic ratio y: Co concentration z: B concentration x)=(0.7: 90 atomic percent: 30 atomic percent), a line (including the line) that runs on the point h and point i (atomic ratio y: Co concentration z: B concentration x)=(0.9: 70 atomic percent: 30 atomic percent), a line (including the line) that runs on the point i and point j (atomic ratio y: Co concentration z: B concentration x)=(0.9: 50 atomic percent: 30 atomic percent), and a line (including the line) that runs on the point j and the point e;
a line (including the line) that runs on point k (atomic ratio y: Co concentration z: B concentration x)=(0.70: 50 atomic percent: 20 atomic percent) and point 1 (atomic ratio y: Co concentration z: B concentration x)=(0.50: 70 atomic percent: 20 atomic percent), a line (including the line) that runs on the point 1 and point m (atomic ratio y: Co concentration z: B concentration x)=(0.50: 90 atomic percent: 20 atomic percent), a line (including the line) that runs on the point m and point n (atomic ratio y: Co concentration z: B concentration x)=(0.7: 90 atomic percent: 20 atomic percent), a line (including the line) that runs on the point n and point o (atomic ratio y: Co concentration z: B concentration x)=(0.9: 70 atomic percent: 20 atomic percent), a line (including the line) that runs on the point o and point p (atomic ratio y: Co concentration z: B concentration x)=(0.9: 50 atomic percent: 20 atomic percent), and a line (including the line) that runs on the point p and the point k; and
a line (including the line) that runs on the point e and the point K, a line (including the line) that runs on the point f and the point 1, a line (including the line) that runs on the point g and the point m, a line (including the line) that runs on the point h and the point n, a line (including the line) that runs on the point i and the point o, and a line (including the line) that runs on the point j and the point p.

Accordingly, a low RA and a high rate of change in resistance (ΔR/R) can be easily and more effectively obtained at the same time, and furthermore, a tunnel type magnetic sensor capable of suppressing the variations in properties can be manufactured.

In addition, according to the present invention, when the insulating barrier layer is formed, it is preferable that after an Al layer is formed, the Al layer be oxidized to form the insulating barrier layer composed of Al-O.

Alternatively, when the insulating barrier layer is formed, the insulating barrier layer composed of Al-O may be directly formed on the barrier layer-side magnetic layer using an Al-O target.

In addition, according to the present invention, after the lamination portion is formed, an annealing treatment is preferably performed. By the conditions of the annealing treatment, element diffusion occurs inside the barrier layer-side magnetic layer, and as a result, the composition gradient region of the B concentration can be formed.

According to the present invention, in a tunnel type magnetic sensor using Al-O for an insulating barrier layer, a low RA and a high rate of change in resistance (ΔR/R) can be simultaneously obtained, and furthermore, variations in properties can be suppressed.

### BRIEF DESCRIPTION OF THE DRAWINGS

Fig. 1 is a cross-sectional view of a tunnel type magnetic sensor according to an embodiment of the present invention, taken along a face parallel to a facing face facing a recording medium;
Fig. 2 includes an enlarged view showing the vicinity of a second fixed magnetic layer 4c shown in Fig. 1, in particular, a partial enlarged cross-sectional view showing occurrence of element diffusion at an interface between a CoFeB layer and an interface layer, and a graph showing the change in B concentration;
Fig. 3 includes a partial enlarged cross-sectional view showing the vicinity of the second fixed magnetic layer 4c shown in Fig. 1 according to an embodiment different from that shown in Fig. 2, and a graph showing the change in B concentration;
Fig. 4 is a view illustrating a step of a manufacturing method of the tunnel type magnetic sensor shown in Fig. 1 (a cross-sectional view of a tunnel type magnetic sensor in process taken along a face parallel to the facing face facing a recording medium);
Fig. 5 is a view illustrating a step following the step shown in Fig. 4 (a cross-sectional view of the tunnel type magnetic sensor in process taken along a face parallel to the facing face facing a recording medium);
Fig. 6 is a view illustrating a step following the step shown in Fig. 5 (a cross-sectional view of the tunnel type magnetic sensor in process taken along a face parallel to the facing face facing a recording medium);
Fig. 7 is a view illustrating a step following the.step shown in Fig. 6 (a cross-sectional view of the tunnel type magnetic sensor in process taken along a face parallel to the facing face facing a recording medium);
Fig. 8 is a graph showing the relationship between a B concentration x of a CoFeB layer and a necessary average thickness t1 of the CoFeB layer;
Fig. 9 is a graph showing the relationship between the B concentration x of the CoFeB layer and a necessary thickness ratio (t2/t1) of an interface layer to the CoFeB layer; and
Fig. 10 is a three-dimensional graph to define a necessary atomic ratio y and a Co concentration z in a lamination structure composed of a CoFeB layer of {Co_{y}Fe_{1-y}}₁₀₀₋ₓBₓ (x indicates, atomic percent) and an interface layer of Co_{z}Fe_{100-z}.

### DESCRIPTION OF THE PREFERRED EMBODIMENTS

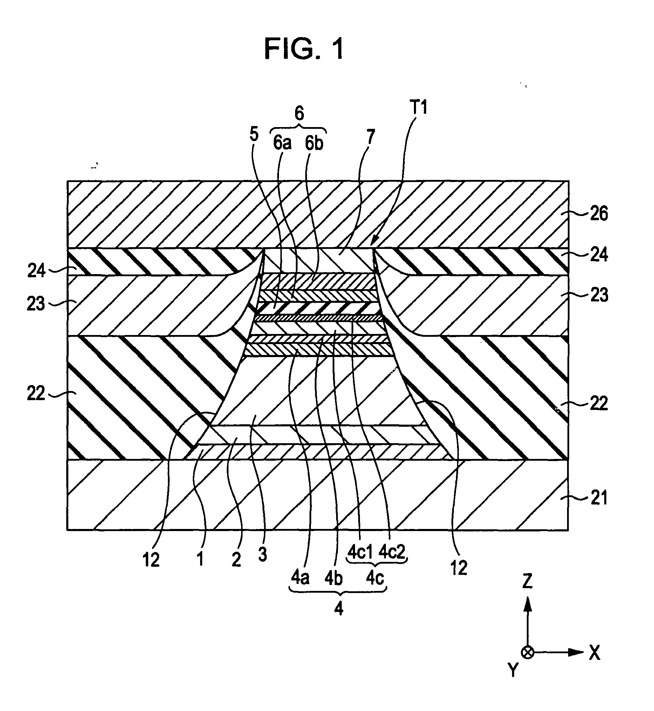

Fig. 1 is a cross-sectional view of a tunnel type magnetic sensor (tunnel type magnetoresistive sensor) according to this embodiment of the present invention, taken along a face parallel to a facing face facing a recording medium.

A tunnel type magnetic sensor is provided at a trailing side end portion or the like of a floating slider provided in a hard disk apparatus and detects a recorded magnetic field from a hard disk or the like. Alternatively, the tunnel type magnetic sensor is also used as a magnetoresistive memory (MRAM) or the like.

In the figure, an X direction indicates a track width direction, a Y direction indicates a direction of a leak magnetic field from a magnetic recording medium (height direction), and a Z direction indicates a traveling direction of a magnetic recording medium, such as a hard disk, and a lamination direction of layers forming the tunnel type magnetic sensor.

A layer formed at the lowest position shown in Fig. 1 is a lower shield layer 21 formed, for example, from a NiFe alloy. A laminate T1 is formed on the lower shield layer 21. The tunnel type magnetic sensor described above includes, besides the laminate T1, lower insulating layers 22, hard bias layers 23, and upper insulating layers 24, which are formed at two sides of the laminate T1 in the track width direction (X direction in the figure).

The lowest layer of the laminate T1 is an underlayer 1 formed of a non-magnetic material including at least one element selected from the group consisting of Ta, Hf, Nb, Zr, Ti, Mo, and W. A seed layer 2 is provided on this underlayer 1. The seed layer 2 is formed, for example, from NiFeCr. When the seed layer 2 is formed of NiFeCr, it has a face-centered cubic (fcc) structure in which equivalent crystalline planes represented by the {111} planes are preferentially oriented in a direction parallel to the surface of the film. Incidentally, the underlayer 1 may not be formed.

An antiferromagnetic layer 3 formed on the seed layer 2 is preferably formed of an antiferromagnetic material containing an element α (where α is at least one element selected from the group consisting of Pt, Pd, Ir, Rh, Ru, and Os) and Mn.

The α-Mn alloy using a platinum group element has superior corrosion resistance and a high blocking temperature, and in addition, as an antiferromagnetic material, this α-Mn alloy has superior properties such that an exchange coupling magnetic field (Hex) can be increased.

In addition, the antiferromagnetic layer 3 may be formed of an antiferromagnetic material containing the element α, an element α' (where α' is at least one element selected from the group consisting of Ne, Ar, Kr, Xe, Be, B, C, N, Mg, A1, Si, P, Ti, V, Cr, Fe, Co, Ni, Cu, Zn, Ga, Ge, Zr, Nb, Mo, Ag, Cd, Sn, Hf, Ta, W, Re, Au, Pb, and rare earth elements), and Mn.

A fixed magnetic layer 4 is formed on the antiferromagnetic layer 3. The fixed magnetic layer 4 has a laminated ferrimagnetic structure composed of a first fixed magnetic layer 4a, a non-magnetic interlayer 4b, and a second fixed magnetic layer 4c laminated to each other in that order from the bottom. By an exchange coupling magnetic field at the interface with the antiferromagnetic layer 3 and an antiferromagnetic exchange coupling magnetic field (PKKY interaction) via the non-magnetic interlayer 4b, the magnetization direction of the first fixed magnetic layer 4a and that of the second fixed magnetic layer 4c are placed in an antiparallel state. This structure is a so-called laminated ferrimagnetic structure, and by this structure, the magnetization of the fixed magnetic layer 4 can be stabilized, and the exchange coupling magnetic field generated at the interface between the fixed magnetic layer 4 and the antiferromagnetic layer 3 can be apparently increased. In addition, the first fixed magnetic layer 4a and the second fixed magnetic layer 4c are formed, for example, to have a thickness of approximately 1.2 to 4.0 nm (12 to 40 Å), and the non-magnetic interlayer 4b is formed to have a thickness of approximately 0.8 to 1 nm (8 to 10 Å).

The first fixed magnetic layer 4a is formed of a ferromagnetic material such as CoFe, NiFe, or CoFeNi. In addition, the non-magnetic interlayer 4b is formed of a non-magnetic conductive material such as Ru, Rh, Ir, Cr, Re, or Cu.

In this embodiment, the second fixed magnetic layer 4c is further composed of a CoFeB layer 4c1 formed of CoFeB and an interface layer 4c2 formed of CoFe or Co.

An insulating barrier layer 5 formed on the fixed magnetic layer 4 is formed of Al-O (aluminum oxide). The insulating barrier layer 5 has a thickness of approximately 0.6 to 1.2 nm.

A free magnetic layer 6 is formed on the insulating barrier layer 5. The free magnetic layer 6 is composed of a soft magnetic layer 6b formed of a magnetic material, such as a NiFe alloy, and an enhancing layer 6a formed of a CoFe alloy and provided between the soft magnetic layer 6b and the insulating barrier layer 5. The soft magnetic layer 6b is preferably formed of a magnetic material having superior soft magnetic properties, and the enhancing layer 6a is formed of a magnetic material having spin polarizability higher than that of the soft magnetic layer 6b. When the enhancing layer 6a is formed of a CoFe alloy having a high spin polarizability, the rate of change in resistance (ΔR/R) can be improved.

The free magnetic layer 6 may also have a laminated ferrimagnetic structure in which magnetic layers are laminated to each other with at least one non-magnetic interlayer provided therebetween. In addition, a track width Tw is determined by the width dimension of the free magnetic layer 6 in the track width direction (X direction in the figure).

A protective layer 7 composed of Ta or the like is formed on the free magnetic layer 6.

Two side end surfaces 12 of the laminate T1 in the track width direction (X direction in the figure) are formed to be inclined surfaces so that the width dimension in the track width direction is gradually decreased from the lower side to the upper side.

As shown in Fig. 1, on the lower shield layer 21 extending to the two sides of the laminate T1 and on the two side end surfaces 12 thereof, the lower insulating layers 22 are formed, the hard bias layers 23 are formed on the lower insulating layers 22, and in addition, on the hard bias layers 23, the upper insulating layers 24 are formed.

A bias underlayer (not shown) may be formed between the lower insulating layer 22 and the hard bias layer 23. The bias underlayer is formed, for example, from Cr, W, or Ti.

The insulating layers 22 and 24 are formed of an insulating material such as Al₂O₃ or SiO₂ and insulate the top and the bottom of the hard bias layer 23 so as to suppress current flowing in a direction perpendicular to the interfaces between the individual layers of the laminate T1 from being shunted to the two sides of the laminate T1 in the track width direction. The hard bias layer 23 is formed, for example, of a Co-Pt (cobalt-platinum) alloy or a Co-Cr-Pt (cobalt-chromium-platinum) alloy.

On the laminate T1 and the upper insulating layers 24, an upper shield layer 26 composed of a NiFe alloy or the like is formed.

In the embodiment shown in Fig. 1, the lower shield layer 21 and the upper shield layer 26 function as electrode layers for the laminate T1, and in a direction perpendicular to the film surfaces of the layers forming the laminate T1 (in a direction parallel to the Z direction in the figure), current flows.

The free magnetic layer 6 is magnetized in a direction parallel to the track width direction (X direction in the figure) by a bias magnetic field from the hard bias layers 23. On the other hand, the first fixed magnetic layer 4a and the second fixed magnetic layer 4c, which form the fixed magnetic layer 4, are magnetized in a direction parallel to the height direction (Y direction in the figure). Since the fixed magnetic layer 4 has a laminated ferrimagnetic structure, the first fixed magnetic layer 4a and the second fixed magnetic layer 4c are magnetized antiparallel to each other. Although the magnetization of the fixed magnetic layer 4 is fixed (the magnetization is not varied by an external magnetic field), the magnetization of the free magnetic layer 6 is varied by an external magnetic field.

When the magnetization of the free magnetic layer 6 is varied by an external magnetic field, and when the magnetization of the second fixed magnetic layer 4c and that of the free magnetic layer 6 are antiparallel to each other, a tunnel current becomes unlikely to flow through the insulating barrier layer 5 provided between the second fixed magnetic layer 4c and the free magnetic layer 6, and hence the resistance is increased to a maximum value. On the other hand, when the magnetization of the second fixed magnetic layer 4c and that of the free magnetic layer 6 are parallel to each other, the tunnel current is most likely to flow, and the resistance is decreased to a minimum value.

With the use of this principle, it is designed that when the magnetization of the free magnetic layer 6 is varied by influence of an external magnetic field, the change in electrical resistance is grasped as the change in voltage, and a leak magnetic field from a recording medium is detected.

Characteristic portions of the embodiment shown in Fig. 1 will be described.

In Fig. 1, the insulating barrier layer 5 is formed of Al-O (aluminum oxide). The second fixed magnetic layer 4c forming the fixed magnetic layer 4 provided under the insulating barrier layer 5 is formed to be in contact therewith and is composed of the CoFeB layer 4c1 formed of CoFeB and the interface layer 4c2 located between the CoFeB layer 4c1 and the insulating barrier layer 5 and formed of CoFe or Co.

By the structure described above, according to experiments which will be described later, it was found that a low RA and a high rate of change in resistance (ΔR/R) can be simultaneously obtained as compared to a related example in which the second fixed magnetic layer 4c is formed of a single CoFeB layer and to a reference example in which the CoFeB layer 4c1 and the interface layer 4c2 are laminated in reverse order. Furthermore, variations in properties, such as the RA and the rate of change in resistance (ΔR/R), can be suppressed. Hence, a high head output can be obtained even when the track width is being narrowed, and as a result, a tunnel type magnetic sensor having superior reliability can be realized with good yield.

It is believed that when the interface layer 4c2 composed of CoFe or Co is provided between the CoFeB layer 4c1 and the insulating barrier layer 5 as is the case of this embodiment, since the concentration of the B element in the vicinity of the interface with the insulating barrier layer 5 is decreased to an appropriate level, the spin polarizability is improved, and in addition, since a sufficient planarization effect can be obtained by the CoFeB layer 4c1 which is likely to be placed in an amorphous state and which has a planarization effect due to the presence of the B element, the film quality of the insulating barrier layer 5 can be improved, so that a low RA and a high rate of change in resistance (ΔR/R) can be simultaneously obtained.

In addition, in this embodiment, the CoFeB layer 4c1 is formed of {Co_{y}Fe_{1-y}}₁₀₀₋ₓBₓ (where y indicates (Co concentration in atomic percent}/(Co concentration + Fe concentration in atomic percent) and is hereinafter referred to as "atomic ratio"), and the B concentration x is preferably in the range of more than 16 to 40 atomic percent. It was found by the experiments to be described later that, as in the case in the past, when the second fixed magnetic layer 4c is formed to have a single CoFeB layer structure, and when the B concentration is set to approximately 16 atomic percent, the RA can be decreased and the rate of change in resistance (ΔR/R) can be increased. According to this embodiment, in the CoFeB layer 4c1 apart from the insulating barrier layer 5, the B concentration is increased to more than 16 atomic percent to facilitate the formation of an amorphous state, so that the flatness of the second fixed magnetic layer 4c is improved. On the other hand, B is not added to the interface layer 4c2 in contact with the insulating barrier layer 5 to decrease the B concentration in the vicinity of the interface with the insulating barrier layer 5 to an appropriate level, so that the spin polarizability is improved. Accordingly, compared to the results obtained in the past, in an effective manner, the RA can be decreased and the rate of change in resistance (ΔR/R) can be increased at the same time. In addition, the variations in properties, that is, the RA and the rate of change in resistance (ΔR/R), can be suppressed as compared to that in the past.

In addition, in the present invention, the B concentration x is more preferably in the range of 17.5 to 35 atomic percent.

In the case described above, the average thickness of the CoFeB layer 4c1 is preferably in the range of a line (including the line) and thereabove in a graph shown in Fig. 8, the line that runs on point (1) (B concentration x: average thickness of the CoFeB layer)=(17.5 atomic percent: 1.65 nm) and point (2) (B concentration x: average thickness of the CoFeB layer)=(35 atomic percent: 0.60 nm). In addition, in a graph shown in Fig. 9, the thickness ratio of the interface layer 4c2 to the CoFeB layer 4c1 (the average thickness of the interface layer 4c2/the average thickness of the CoFeB layer 4c1) is preferably in the range surrounded by a line that runs on point A (B concentration x: thickness ratio)=(17.5 atomic percent: 0.00) and point B (B concentration x: thickness ratio)=(35 atomic percent: 0.70) (including the line, however the point A is excluded), a line that runs on the point B and point C (B concentration x: thickness ratio)=(35 atomic percent: 1.65) (including the line), a line that runs on the point C and point D (B concentration x: thickness ratio)=(17.5 atomic percent: 0.43) (including the line), and a line that runs on the point D and the point A (including the line, however the point A is excluded).

Furthermore, when the B concentration x is in the range of 17.5 to 35 atomic percent, the atomic ratio y of the CoFeB layer 4c1 and a Co concentration z of the interface layer 4c2 are preferably defined within a polyhedron in a three-dimensional graph shown in Fig. 10 surrounded by:
a line (including the line) that runs on point E (atomic ratio y: Co concentration z: B concentration x)=(0.4: 50 atomic percent: 35 atomic percent) and point F (atomic ratio y: Co concentration z: B concentration x)=(0.05: 70 atomic percent: 35 atomic percent), a line (including the line) that runs on the point F and point G (atomic ratio y: Co concentration z: B concentration x)=(0.05: 90 atomic percent: 35 atomic percent), a line (including the line) that runs on the point G and point H (atomic ratio y: Co concentration z: B concentration x)=(0.7: 90 atomic percent: 35 atomic percent), a line (including the line) that runs on the point H and point I (atomic ratio y: Co concentration z: B concentration x)=(0.9: 70 atomic percent: 35 atomic percent), a line (including the line) that runs on the point I and point J (atomic ratio y: Co concentration z: B concentration x)=(0.9: 50 atomic percent: 35 atomic percent), and a line (including the line) that runs on the point J and the point E;
a line (including the line) that runs on point K (atomic ratio y: Co concentration z: B concentration x)=(0.75: 50 atomic percent: 17.5 atomic percent) and point L (atomic ratio y: Co concentration z: B concentration x)=(0.58: 70 atomic percent: 17.5 atomic percent), a line (including the line) that runs on the point L and point M (atomic ratio y: Co concentration z: B concentration x)=(0.58: 90 atomic percent: 17.5 atomic percent), a line (including the line) that runs on the point M and point N (atomic ratio y: Co concentration z: B concentration x)=(0.7: 90 atomic percent: 17.5 atomic percent), a line (including the line) that runs on the point N and point O (atomic ratio y: Co concentration z: B concentration x)=(0.9: 70 atomic percent: 17.5 atomic percent), a line (including the line) that runs on the point O and point P (atomic ratio y: Co concentration z: B concentration x)=(0.9: 50 atomic percent: 17.5 atomic percent), and a line (including the line) that runs on the point P and the point K; and
a line (including the line) that runs on the point E and the point K, a line (including the line) that runs on the point F and the point L, a line (including the line) that runs on the point G and the point M, a line (including the line) that runs on the point H and the point N, a line (including the line) that runs on the point I and the point O, and a line (including the line) that runs on the point J and the point P.

According to the experiments to be described below, it was found that the absolute thickness of the CoFeB layer 4c1 and the thickness ratio of the interface layer 4c2 to the CoFeB layer 4c1, which are optimum to simultaneously obtain a low RA and a high rate of change in resistance (ΔR/R), are changed by the B concentration x. When the B concentration x is in the range of 17.5 to 35 atomic percent, by controlling the average thickness of the CoFeB layer 4c1 and the thickness ratio of the interface layer 4c2 to the CoFeB layer 4c1 as described above, a low RA and a high rate of change in resistance (ΔR/R) can be effectively obtained at the same time.

In addition, when the atomic ratio y of the CoFeB layer 4c1 and the Co concentration z of the interface layer 4c2 are controlled as described above, a low RA and a high rate of change in resistance (ΔR/R) can be effectively obtained at the same time.

In addition, in the three-dimensional graph shown in Fig. 10, it is preferable that the points E and I be connected by a line (including the line) and that the points K and O be connected by a line (including the line). That is, in the three-dimensional graph shown in Fig. 10, when the B concentration x is in the range of 17.5 to 35 atomic percent, the atomic ratio y of the CoFeB layer 4c1 and the Co concentration z of the interface layer 4c2 formed of Co_{z}Fe_{100-z} are more preferably defined within a polyhedron surrounded by:
the line (including the line) that runs on the points E and I, the line (including the line) that runs on the points E and F, the line (including the line) that runs on the points F and G, the line (including the line) that runs on the points G and H, and the line (including the line) that runs on the points H and I;
the line (including the line) that runs on the points K and O, the line (including the line) that runs on the points K and L, the line (including the line) that runs on the points L and M, the line (including the line) that runs on the points M and N, and the line (including the line) that runs on the points N and O; and
the line (including the line) that runs on the points E and K, the line (including the line) that runs on the points F and L, the line (including the line) that runs on the points G and M, the line (including the line) that runs on the points H and N, and the line (including the line) that runs on the points I and O. Accordingly, the variations in RA and rate of change in resistance (ΔR/R) can be effectively suppressed.

In addition, according to this embodiment, the B concentration x is preferably in the range of 20 to 30 atomic percent.

In the case described above, the average thickness of the CoFeB layer 4c1 is preferably in the range of a line (including the line) and thereabove in the graph shown in Fig. 8, the line that runs on point (3) (B concentration x: average thickness of the CoFeB layer)=(20 atomic percent: 1.5 nm) and point (4) (B concentration x: average thickness of the CoFeB layer)=(30 atomic percent: 0.90 nm), and in the graph shown in Fig. 9, the thickness ratio of the interface layer 4c2 to the CoFeB layer 4c1 (average thickness of the interface layer/average thickness of the CoFeB layer) is preferably in the range surrounded by a line (including the line) that runs on point a (B concentration x: thickness ratio)=(20.0 atomic percent: 0.10) and point b (B concentration x: thickness ratio)=(30 atomic percent: 0.50), a line (including the line) that runs on the point b and point c (B concentration x: thickness ratio)=(30 atomic percent: 1.30), a line (including the line) that runs on the point c and point d (B concentration x: thickness ratio)=(20 atomic percent: 0.60), and a line (including the line) that runs on the point d and the point a.

Furthermore, when the B concentration x is in the range of 20 to 30 atomic percent, the atomic ratio y of the CoFeB layer and the Co concentration z of the interface layer formed of Co_{z}fe_{100-z} are preferably defined within a polyhedron in the three-dimensional graph shown in Fig. 10 surrounded by:
a line (including the line) that runs on point e (atomic ratio y: Co concentration z: B concentration x)=(0.5: 50 atomic percent: 30 atomic percent) and point f (atomic ratio y: Co concentration z: B concentration x)=(0.20: 70 atomic percent: 30 atomic percent), a line (including the line) that runs on the point f and point g (atomic ratio y: Co concentration z: B concentration x)=(0.20: 90 atomic percent: 30 atomic percent), a line (including the line) that runs on the point g and point h (atomic ratio y: Co concentration z: B concentration x)=(0.7: 90 atomic percent: 30 atomic percent), a line (including the line) that runs on the point h and point i (atomic ratio y: Co concentration z: B concentration x)=(0.9: 70 atomic percent: 30 atomic percent), a line (including the line) that runs on the point i and point j (atomic ratio y: Co concentration z: B concentration x)=(0.9: 50 atomic percent: 30 atomic percent), and a line (including the line) that runs on the point j and the point e;
a line (including the line) that runs on point k (atomic ratio y: Co concentration z: B concentration x)=(0.70: 50 atomic percent: 20 atomic percent) and point 1 (atomic ratio y: Co concentration z: B concentration x)=(0.50: 70 atomic percent: 20 atomic percent), a line (including the line) that runs on the point 1 and point m (atomic ratio y: Co concentration z: B concentration x)=(0.50: 90 atomic percent: 20 atomic percent), a line (including the line) that runs on the point m and point n (atomic ratio y: Co concentration z: B concentration x)=(0.7: 90 atomic percent: 20 atomic percent), a line (including the line) that runs on the point n and point o (atomic ratio y: Co concentration z: B concentration x)=(0.9: 70 atomic percent: 20 atomic percent), a line (including the line) that runs on the point o and point p (atomic ratio y: Co concentration z: B concentration x)=(0.9: 50 atomic percent: 20 atomic percent), and a line (including the line) that runs on the point p and the point k; and
a line (including the line) that runs on the point e and the point K, a line (including the line) that runs on the point f and the point 1, a line (including the line) that runs on the point g and the point m, a line (including the line) that runs on the point h and the point n, a line (including the line) that runs on the point i and the point o, and a line (including the line) that runs on the point j and the point p.

According to the definition described above, a low RA and a high rate of change in resistance (ΔR/R) can be effectively obtained at the same time.

In addition, in the three-dimensional graph in Fig. 10, it is preferable that the point e and the point i be connected to each other by a line (including the line) and that the point k and the point o be connected to each other by a line (including the line). That is, when the B concentration x is in the range of 20 to 30 atomic percent, the atomic ratio y of the CoFeB layer 4c1 and the Co concentration z of the interface layer 4c2 formed of Co_{z}Fe_{100-z} are more preferably defined within a polyhedron of the three-dimensional graph shown in Fig. 10 surrounded by: the line (including the line) that runs on the points e and i, the line (including the line) that runs on the points e and f, the line (including the line) that runs on the points f and g, the line (including the line) that runs on the points g and h, and the line (including the line) that runs on the points h and I;
the line (including the line) that runs on the points k and o, the line (including the line) that runs on the points k and 1, the line (including the line) that runs on the points 1 and m, the line (including the line) that runs on the points m and n, and the line (including the line) that runs on the points n and o; and
the line (including the line) that runs on the points e and k, the line (including the line) that runs on the points f and 1, the line (including the line) that runs on the points g and m, the line (including the line) that runs on the points h and n, and the line (including the line) that runs on the points i and o. Accordingly, the variations in properties, such as the RA and the rate of change in resistance (ΔR/R), can be effectively suppressed.

In addition, the total thickness of the second fixed magnetic layer 4c is preferably 4 nm or less. When the thickness of the second fixed magnetic layer 4c is increased, since the magnetization fixing force of the fixed magnetic layer 4 decreases, the properties may be degraded; hence, the average thickness of the second fixed magnetic layer 4c is preferably set to 4 nm at a maximum.

In addition, according to this embodiment, an interlayer coupling magnetic field Hin caused by a topological magnetostatic coupling between the fixed magnetic layer 4 and the free magnetic layer 6 can be decreased by defining the average thickness of the CoFeB layer 4c1 as described above. The decrease in the interlayer coupling magnetic field Hin means that the flatness of the interface between the second fixed magnetic layer 4c and the insulating barrier layer 5 is improved.

In this embodiment, without decreasing the rate of change in resistance (ΔR/R) as compared to that in the past, a low RA can be obtained as described above. Since being a very important value for optimization of high-speed data transfer, an increase in high-recording density, and the like, the RA must be set to a small value. In this embodiment, the RA can be set to a small value as compared to that in the past. In particular, the RA can be set to less than 5.8 Ω·µm² which is a value of a related example, and in particular, the RA can be decreased from that of the related example by approximately 0.4 to 0.8 Ω·µm².

For the tunnel type magnetic sensor, an annealing treatment (heat treatment) is performed in a manufacturing process, as described below. The annealing treatment is performed, for example, at a temperature of approximately 240 to 310°C. This annealing treatment is, for example, an annealing treatment in a magnetic field in which an exchange coupling magnetic field (Hex) is generated between the antiferromagnetic layer 3 and the first fixed magnetic layer 4a forming the fixed magnetic layer 4.

When the temperature of the annealing treatment is less than 240°C, or when the annealing time is less than 1 hour even at a temperature in the range of 240 to 310°C, no counter diffusion of constituent elements occurs at the interface between the interface layer 4c2 and the CoFeB layer 4c1, or even if the counter diffusion occurs, the degree thereof is not significant (for example, diffusion does not occur at the entire interface but only intermittently occurs), and it is believed that the state of the interface is practically maintained.

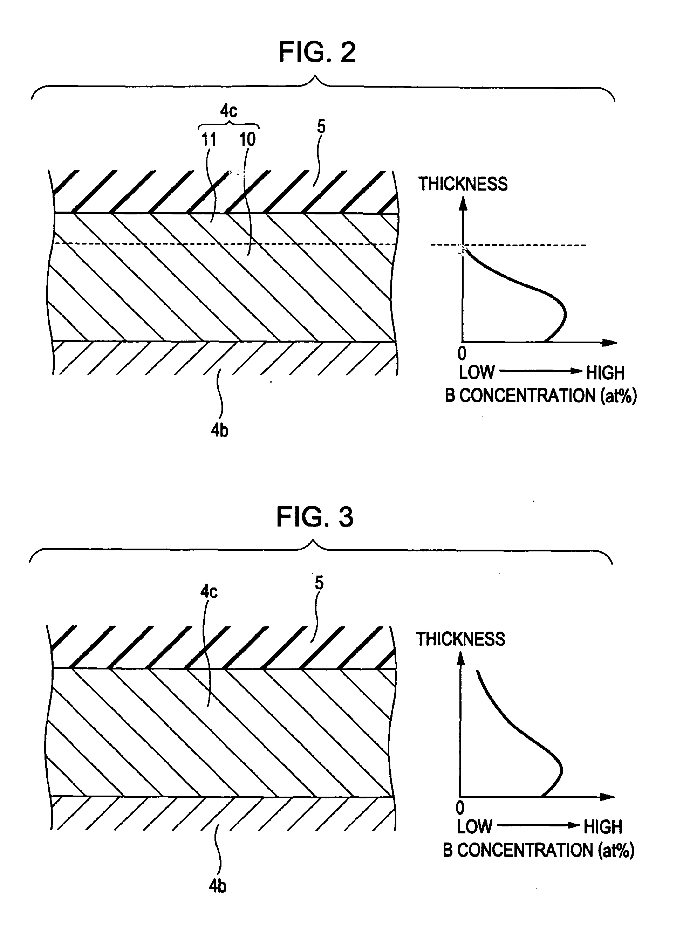

On the other hand, when the temperature of the annealing treatment is more than 310°C, or when the annealing time is 1 hour or more and the annealing temperature is in the range of 240 to 310°C, counter diffusion of constituent elements occurs at the interface between the interface layer 4c2 and the CoFeB layer 4c1, as shown in Fig. 2 or 3, and the interface described above disappears; hence, it is believed that the composition gradient region of the B concentration is formed.

In the embodiment shown in Fig. 2, element diffusion occurs at the interface between the interface layer 4c2 and the CoFeB layer 4c1, and as a result, the second fixed magnetic layer 4c is composed of a CoFeB region 10 formed of CoFeB and an intervening region 11 which is formed of CoFe or Co and which is located between the CoFeB region 10 and the insulating barrier layer 5.

As shown in Fig. 2, B is not contained in the intervening region 11. As shown at the right side of Fig. 2, in the CoFeB region 10, there is a composition gradient region in which the B concentration gradually decreases from a lower surface side (side at the interface in contact with the non-magnetic interlayer 4b) toward the intervening region 11. In addition, in the vicinity of the lower surface of the CoFeB region 10, the B concentration decreases as compared to that at the inner side, and the reason for this decrease is the element diffusion with the non-magnetic interlayer 4b.

On the other hand, in the embodiment shown in Fig. 3, although the second fixed magnetic layer 4c is entirely formed of CoFeB, the B concentration at an upper surface side in contact with the insulating barrier layer 5 is lower than that at a lower surface side in contact with the non-magnetic interlayer 4b. In addition, as shown in Fig. 3, in the second fixed magnetic layer 4c, there is a composition gradient region in which the B concentration gradually decreases from the lower surface side in contact with the non-magnetic interlayer 4b toward the upper surface side in contact with the insulating barrier layer 5. In addition, as shown in Fig. 3, in the vicinity of the lower surface of the second fixed magnetic layer 4c, the B concentration decreases as compared to that at the inner side, and the reason for this decrease is the element diffusion with the non-magnetic interlayer 4b.

As described above, at the lower surface side apart from the insulating barrier layer 5, since the B concentration is high, an amorphous texture is easily formed, and flatness is easily obtained, so that improvement in uniformity of the insulating barrier layer 5, reduction in defects, such as pinholes, and improvement in quality can be achieved. In addition, at the upper surface side in contact with the insulating barrier layer 5, since the B concentration is decreased to an appropriate level by adjustment, the spin polarizability can be maximized. Accordingly, it is believed that a low RA and a high rate of change in resistance (ΔR/R) can be simultaneously obtained, and that the variations thereof can be suppressed.

In addition, in the embodiment shown in Fig. 1, the fixed magnetic layer 4 has a laminated ferrimagnetic structure including the first fixed magnetic layer 4a, the non-magnetic interlayer 4b, and the second fixed magnetic layer 4c; however, for example, even when the fixed magnetic layer 4 is formed of a single layer or has a laminated structure including a plurality of magnetic layers, this embodiment can be applied thereto. However, when the fixed magnetic layer 4 has a laminated ferrimagnetic structure, as described above, since the magnetization of the fixed magnetic layer 4 can be more appropriately fixed, improvement in reproduction output can be preferably performed.

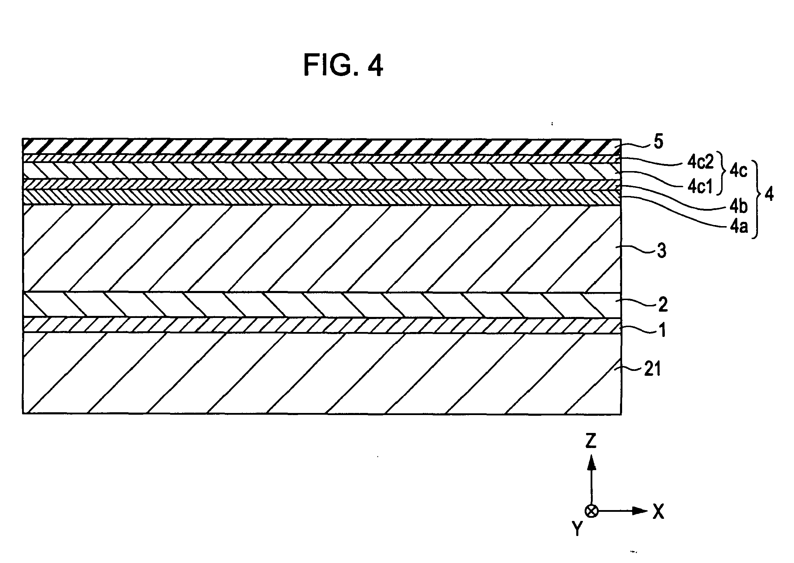

A method for manufacturing a tunnel type magnetic sensor according to this embodiment will be described. Figs. 4 to 7 are partial cross-sectional views each showing a tunnel type magnetic sensor in process taken along the same direction as that shown in Fig. 1.

In a step shown in Fig. 4, on the lower shield layer 21, the underlayer 1, the seed layer 2, the antiferromagnetic layer 3, the first fixed magnetic layer 4a, the non-magnetic interlayer 4b, and the second fixed magnetic layer 4c are sequentially formed. For example, the individual layers are formed by sputtering.

In this embodiment, as shown in Fig. 4, the second fixed magnetic layer 4c are formed by laminating the CoFeB layer 4c1 formed of CoFeB and the interface layer 4c2 formed of CoFe or Co in that order from the bottom.

In this step, in order to simultaneously obtain a low RA and a high rate of change in resistance (ΔR/R), the CoFeB layer 4c1 is preferably formed of (Co_{1-y}Fe_{y})₁₀₀₋ₓBₓ and the B concentration x is preferably set in the range of more than 16 to 40 atomic percent.

In addition, in this embodiment, the B concentration x is more preferably set in the range of 17.5 to 35 atomic percent.

In this case, the average thickness of the CoFeB layer 4c1 is preferably formed in the range of a line (including the line) and thereabove in the graph shown in Fig. 8, the line that runs on the point (1) (B concentration x: average thickness of the CoFeB layer)=(17.5 atomic percent: 1.65 nm) and the point (2) (B concentration x: average thickness of the CoFeB layer)=(35 atomic percent: 0.60 nm). In addition, in the graph shown in Fig. 9, the thickness ratio of the interface layer 4c2 to the CoFeB layer 4c1 (average thickness of the interface layer 4c2/average thickness of the CoFeB layer 4c1) is preferably adjusted in the range surrounded by the line that runs on the point A (B concentration x: thickness ratio)=(17.5 atomic percent: 0.00) and the point B (B concentration x: thickness ratio)=(35 atomic percent: 0.70) (including the line, however the point A is excluded), the line that runs on the point B and the point C (B concentration x: thickness ratio)=(35 atomic percent: 1.65) (including the line), the line that runs on the point C and the point D (B concentration x: thickness ratio)=(17.5 atomic percent: 0.43) (including the line), and the line that runs on the point D and the point A (including the line, however the point A is excluded).

Furthermore, when the B concentration x is formed in the range of 17.5 to 35 atomic percent, and the atomic ratio y of the CoFeB layer 4c1 and the Co concentration z of the interface layer 4c2 formed of Co_{z}Fe_{100-z} are preferably adjusted within a polyhedron in the three-dimensional graph shown in Fig. 10 surrounded by:
the line (including the line) that runs on the point E (atomic ratio y: Co concentration z: B concentration x)=(0.4: 50 atomic percent: 35 atomic percent) and the point F (atomic ratio y: Co concentration z: B concentration x)=(0.05: 70 atomic percent: 35 atomic percent), the line (including the line) that runs on the point F and the point G (atomic ratio y: Co concentration z: B concentration x)=(0.05: 90 atomic percent: 35 atomic percent), the line (including the line) that runs on the point G and the point H (atomic ratio y: Co concentration z: B concentration x)=(0.7: 90 atomic percent: 35 atomic percent), the line (including the line) that runs on the point H and the point I (atomic ratio y: Co concentration z: B concentration x)=(0.9: 70 atomic percent: 35 atomic percent), the line (including the line) that runs on the point I and the point J (atomic ratio y: Co concentration z: B concentration x)=(0.9: 50 atomic percent: 35 atomic percent), and the line (including the line) that runs on the point J and the point E;
the line (including the line) that runs on the point K (atomic ratio y: Co concentration z: B concentration x)=(0.75: 50 atomic percent: 17.5 atomic percent) and the point L (atomic ratio y: Co concentration z: B concentration x)=(0.58: 70 atomic percent: 17.5 atomic percent), the line (including the line) that runs on the point L and the point M (atomic ratio y: Co concentration z: B concentration x)=(0.58: 90 atomic percent: 17.5 atomic percent), the line (including the line) that runs on the point M and the point N (atomic ratio y: Co concentration z: B concentration x)=(0.7: 90 atomic percent: 17.5 atomic percent), the line (including the line) that runs on the point N and the point O (atomic ratio y: Co concentration z: B concentration x)=(0.9: 70 atomic percent: 17.5 atomic percent), the line (including the line) that runs on the point O and the point P (atomic ratio y: Co concentration z: B concentration x)=(0.9: 50 atomic percent: 17.5 atomic percent), and the line (including the line) that runs on the point P and the point K; and
the line (including the line) that runs on the point E and the point K, the line (including the line) that runs on the point F and the point L, the line (including the line) that runs on the point G and the point M, the line (including the line) that runs on the point H and the point N, the line (including the line) that runs on the point I and the point O, and the line (including the line) that runs on the point J and the point P.

In addition, in this embodiment, the B concentration x is preferably formed in the range of 20 to 30 atomic percent.

In this case, the average thickness of the CoFeB layer 4c1 is preferably formed in the range of a line (including the line) and thereabove in the graph shown in Fig. 8, the line that runs on the point (3) (B concentration x: average thickness of the CoFeB layer 4c1)=(20 atomic percent: 1.5 nm) and the point (4) (B concentration x: average thickness of the CoFeB layer 4c1)=(30 atomic percent: 0.90 nm). In addition, in the graph shown in Fig. 9, the thickness ratio of the interface layer 4c2 to the CoFeB layer 4c1 (average thickness of the interface layer 4c2/average thickness of the CoFeB layer 4c1) is adjusted in the range surrounded by the line (including the line) that runs on the point a (B concentration x: thickness ratio)=(20.0 atomic percent: 0.10) and the point b (B concentration x: thickness ratio)=(30 atomic percent: 0.50), the line (including the line) that runs on the point b and the point c (B concentration x: thickness ratio)=(30 atomic percent: 1.30), the line (including the line) that runs on the point c and the point d (B concentration x: thickness ratio)=(20 atomic percent: 0.60), and the line (including the line) that runs on the point d and the point a.

Furthermore, when the B concentration x is formed in the range of 20 to 30 atomic percent, the atomic ratio y of the CoFeB layer 4c1 and the Co concentration z of the interface layer 4c2 formed of Co_{z}Fe_{100-z} are preferably adjusted within a polyhedron in the three-dimensional graph shown in Fig. 10 surrounded by:
the line (including the line) that runs on the point e (atomic ratio y: Co concentration z: B concentration x)=(0.5: 50 atomic percent: 30 atomic percent) and the point f (atomic ratio y: Co concentration z: B concentration x)=(0.20: 70 atomic percent: 30 atomic percent), the line (including the line) that runs on the point f and the point g (atomic ratio y: Co concentration z: B concentration x)=(0.20: 90 atomic percent: 30 atomic percent), the line (including the line) that runs on the point g and the point h (atomic ratio y: Co concentration z: B concentration x)=(0.7: 90 atomic percent: 30 atomic percent), the line (including the line) that runs on the point h and the point i (atomic ratio y: Co concentration z: B concentration x)=(0.9: 70 atomic percent: 30 atomic percent), the line (including the line) that runs on the point i and the point j (atomic ratio y: Co concentration z: B concentration x)=(0.9: 50 atomic percent: 30 atomic percent), and the line (including the line) that runs on the point j and the point e;
the line (including the line) that runs on the point k (atomic ratio y: Co concentration z: B concentration x)=(0.70: 50 atomic percent: 20 atomic percent) and the point 1 (atomic ratio y: Co concentration z: B concentration x)=(0.50: 70 atomic percent: 20 atomic percent), the line (including the line) that runs on the point 1 and the point m (atomic ratio y: Co concentration z: B concentration x)=(0.50: 90 atomic percent: 20 atomic percent), the line (including the line) that runs on the point m and the point n (atomic ratio y: Co concentration z: B concentration x)=(0.7: 90 atomic percent: 20 atomic percent), the line (including the line) that runs on the point n and the point o (atomic ratio y: Co concentration z: B concentration x)=(0.9: 70 atomic percent: 20 atomic percent), the line (including the line) that runs on the point o and the point p (atomic ratio y: Co concentration z: B concentration x)=(0.9: 50 atomic percent: 20 atomic percent), and the line (including the line) that runs on the point p and the point k; and
the line (including the line) that runs on the point e and the point K, the line (including the line) that runs on the point f and the point 1, the line (including the line) that runs on the point g and the point m, the line (including the line) that runs on the point h and the point n, the line (including the line) that runs on the point i and the point o, and the line (including the line) that runs on the point j and the point p. Accordingly, a tunnel type magnetic sensor can be easily and appropriately manufactured which simultaneously has a low Ra, a high rate of change in resistance (ΔR/R), and small variations in properties.

Next, a plasma treatment is performed on the surface of the second fixed magnetic layer 4c. The above plasma treatment is performed to improve the flatness of the surface of the second fixed magnetic layer 4c; however, in the structure in which the interface layer 4c2 having a small thickness is provided on the CoFeB layer 4c1 having superior flatness as is the case of this embodiment, since the flatness of the surface of the second fixed magnetic layer 4c is originally superior, whether the plasma treatment is performed or not may be optionally determined. 02 Next, on the second fixed magnetic layer 4c, the insulating barrier layer 5 composed of Al-O is formed. In this embodiment, an Al layer is formed on the second fixed magnetic layer 4c by sputtering, followed by oxidation of the Al layer, so that the insulating barrier layer 5 composed of Al-O is formed. As an oxidation method, for example, radical oxidation, ion oxidation, plasma oxidation, or natural oxidation may be mentioned.

In this embodiment, the Al layer is formed to have a thickness of approximately 0.2 to 0.6 nm.

In addition, the insulating barrier layer 5 composed of Al-O may be directly formed, for example, by an RF sputtering method using a target of Al-O.

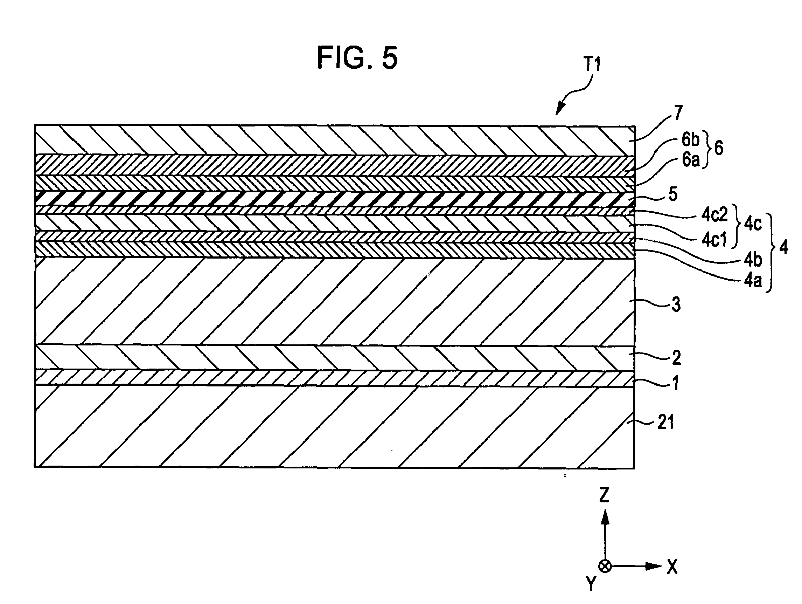

Next, in a step shown in Fig. 5, on the insulating barrier layer 5, the free magnetic layer 6, which is composed of the enhancing layer 6a and the soft magnetic layer 6b, and the protective layer 7 are formed.

In this embodiment, the enhancing layer 6a is preferably formed of CoFe having an Fe composition ratio of 5 to 90 atomic percent. In addition, the soft magnetic layer 6b is preferably formed of an NiFe alloy having a Ni composition ratio of 78 to 96 atomic percent.

Accordingly, the laminate T1 containing from the underlayer 1 to the protective layer 7 laminated to each other is formed.

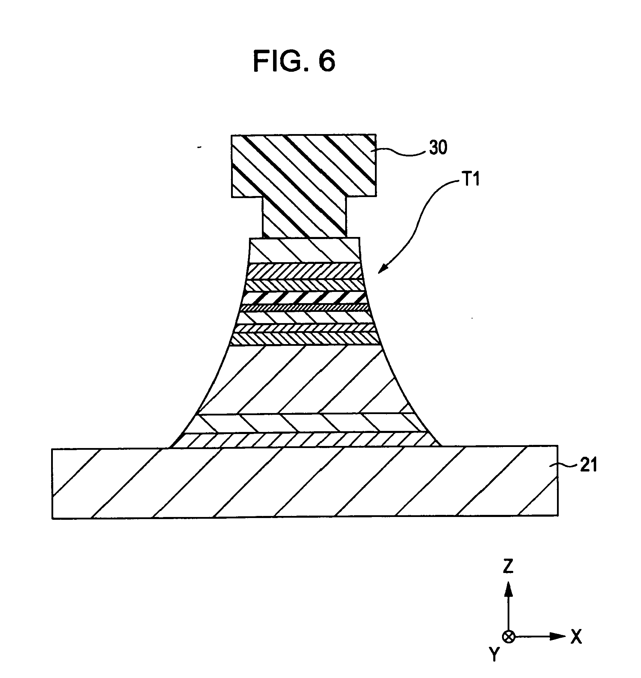

Next, on the laminate T1, a lift-off resist layer 30 is formed, and two side end portions of the laminate T1 in the track width direction (X direction in the figure), which are not covered with the lift-off resist layer 30, are removed by etching or the like (see Fig. 6).

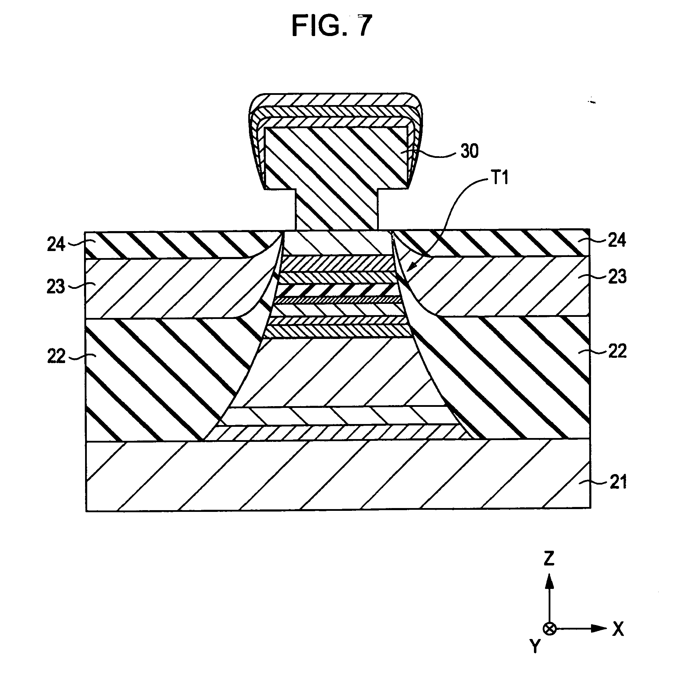

Next, on the lower shield layer 21 at the two sides of the laminate T1 in the track width direction (X direction in the figure), the lower insulating layers 22, the hard bias layers 23, and the upper insulating layers 24 are laminated in that order from the bottom (see Fig. 7).

Subsequently, the lift-off resist layer 30 is removed, and the upper shield layer 26 is formed on the laminate T1 and the upper insulating layers 24.

In the method for manufacturing a tunnel type magnetic sensor, described above, an annealing treatment is performed in the manufacturing process. As a typical annealing treatment, an annealing treatment to generate an exchange coupling magnetic field (Hex) between the antiferromagnetic layer 3 and the first fixed magnetic layer 4a may be mentioned.

When the temperature of the annealing treatment is less than 240°C, or when the annealing time is less than 1 hour even at a temperature in the range of 240 to 310°C, no counter diffusion of constituent elements occurs at interfaces between the layers, or even if the counter diffusion occurs, the degree thereof is not significant (for example, diffusion does not occur at the entire interface but only intermittently occurs), and it is believed that the state of the interface is practically maintained.

On the other hand, when the temperature of the annealing treatment is more than 310°C, or when the annealing time is 1 hour or more and the annealing temperature is in the range of 240 to 310°C, it is believed that counter diffusion of constituent elements occurs at the interfaces between the layers. By the counter diffusion as described above, it is believed that as shown in Figs. 2 and 3, the interface between the CoFeB layer 4c1 and the interface layer 4c2 disappears inside the second fixed magnetic layer 4c so that the composition gradient region of the B concentration is formed.

By the manufacturing method according to this embodiment, a low RA (element resistance R × element area A) and a high rate of change in resistance (ΔR/R) can be simultaneously obtained, and furthermore, a tunnel type magnetic sensor having small variations in properties can be easily and appropriately manufactured.

In particular, compared to the related example in which the second fixed magnetic layer 4c is formed of a single CoFeB layer by adjusting a material for and a thickness ratio of the second fixed magnetic layer 4c as described above, or to the reference example in which the CoFeB layer 4c1 and the interface layer 4c2, which form the second fixed magnetic layer 4c, are laminated in reverse order., a low RA and a high rate of change in resistance (ΔR/R) can be effectively obtained at the same time. In addition, the variations in properties, such as the RA and the rate of change in resistance (ΔR/R), can be effectively suppressed.

In order to form the second fixed magnetic layer 4c having the composition gradient region of the B concentration shown in Figs. 2 and 3, besides the manufacturing method described above, a method may also be performed having the steps of preparing a plurality of Co-Fe-B targets having different B concentrations, and performing sputtering to form the second fixed magnetic layer 4c while the targets are being changed so as to gradually decrease the B concentration.

### Examples

### (Experiment to define B concentration x of CoFeB layer 4c1)

A substrate; the underlayer 1 of Ta (3); the seed layer 2 of (Ni_{0.8}Fe_{0.2})_{60at%}Cr_{40at%} (5); the antiferromagnetic layer 3 of IrMn (7); the fixed magnetic layer 4 composed of the first fixed magnetic layer 4a of Co_{70at%}Fe_{30at%} (1.4), the non-magnetic interlayer 4b of Ru (0.9), and the second fixed magnetic layer 4c (1.8); the insulating barrier layer 5 of Al-O; the free magnetic layer 6 composed of the enhancing layer 6a of Co_{50at%}Fe_{50at%} (1) and the soft magnetic layer 6b of Ni_{85at%}Fe_{15at%} (5); and the protective layer 7 of Ru(2)/Ta(27) were laminated to each other in that order from the bottom. In addition, the value in the parentheses indicates the average thickness, and the unit thereof is nm.

An Al layer having a thickness of 0.43 nm was formed, followed by oxidation thereof, so that the insulating barrier layer 5 was formed.

In addition, the surface of the second fixed magnetic layer 4c was processed by a plasma treatment before the insulating barrier layer 5 was formed.

In the experiment, as the second fixed magnetic layer 4c, there were formed a single layer structure 1 (related example) composed of (Co_{0.75}Fe_{0.25})₁₀₀₋ₓBₓ (t1), a laminated structure 1 containing (Co_{0.75}Fe_{0.25})₁₀₀₋ₓBₓ (t1) and Co_{75at%}Fe_{25at%} (t2) laminated in that order from the bottom, and a laminated structure 2 (lamination structure described in the above Japanese Unexamined Patent Application Publications; reference example) containing Co_{75at%}Fe_{25at%} (t2) and (CO_{0.75}Fe_{0.25})₁₀₀₋ₓBₓ (t1) laminated in that order from the bottom.

In this example, the B concentration x was represented by atomic percent. The average thicknesses t1 and t2 were represented by nm, and the total thickness of the second fixed magnetic layer 4c was adjusted to be 1.8 nm.

In the experiment, the RA and the rate of change in resistance (ΔR/R) were obtained from the individual tunnel type magnetic sensors having the above second fixed magnetic layers 4c. The experimental results are shown in Table 1.

**Table 1**

| | Second fixed magnetic layer | | | | RA | ΔR/R |
|---|---|---|---|---|---|---|
| | B CoFeB B CONCENTRATION (at.%) | CoFeB thickness t1(nm) | CoFeB thickness t2(nm) | Total thickness (nm) | (Ω·µm²) | (%) |
| single layer structure (related example) | 30 | 1.8 | 0.0 | 1.8 | 3.83 | 16.4 |
| | 25 | 1.8 | 0.0 | 1.8 | 3.62 | 21.6 |
| | 21 | 1.8 | 0.0 | 1.8 | 3.41 | 25.1 |
| | 16 | 1.8 | 0.0 | 1.8 | 3.25 | 26.2 |
| | 11 | 1.8 | 0.0 | 1.8 | 2.59 | 17.1 |
| Laminated structure 1 | 30 | 1.5 | 0.3 | 1.8 | 3.58 | 23.5 |
| | 30 | 1.2 | 0.6 | 1.8 | 3.29 | 27.8 |
| | 30 | 0.9 | 0.9 | 1.8 | 3.16 | 28.5 |
| | 30 | 0.6 | 1.2 | 1.8 | 2.71 | 23.4 |
| | 20 | 1.5 | 0.3 | 1.8 | 3.19 | 27.2 |
| | 20 | 1.2 | 0.6 | 1.8 | 3.07 | 27.2 |
| | 20 | 0.9 | 0.9 | 1.8 | 2.09 | 15.9 |
| | 16 | 1.5 | 0.3 | 1.8 | 3.06 | 25.3 |
| | 16 | 1.2 | 0.6 | 1.8 | 1.95 | 14.2 |
| Laminated structure 2 (reference example) | 20 | 1.5 | 0.3 | 1.8 | 3.17 | 23.6 |
| | 20 | 1.2 | 0.6 | 1.8 | 3.11 | 21.1 |
| | 20 | 0.9 | 0.9 | 1.8 | 3.04 | 18.7 |

As shown in Table 1, it was found that in the single layer structure 1 (related example), when the B concentration x was set to approximately 16 atomic percent, a low RA and a high rate of change in resistance (ΔR/R) could be simultaneously obtained.

In the laminated structure 1, it was found that when the B concentration x was set to 16 atomic percent, an effect of decreasing the RA and an effect of increasing the rate of change in resistance (ΔR/R) could not be obtained so much as compared to the conventional single layer structure 1. On the other hand, when the B concentration x was increased to more than 16 atomic percent, it was found that while the RA was decreased to a low value, the rate of change in resistance (ΔR/R) could be increased.

In addition, in the laminated structure 2 (reference example) in which the lamination was performed in an order reverse to that of the laminated structure 1, although the RA was decreased to a low value, the rate of change in resistance (ΔR/R) was decreased, and hence the increasing effect could not be obtained.

Although the laminates used in the above experiment were each in the form of a solid film, in the following experiment, the same laminates as those described above (however, samples were included in which the first fixed magnetic layer 4a and/or the second fixed magnetic layer 4c had a different thickness) were each machined to have the shape of the tunnel type magnetic sensor shown in Fig. 1, and the variations in RA and rate of change in resistance (ΔR/R) were measured.

In the experiment, one tunnel type magnetic sensor having a B concentration x of 16 atomic percent was selected among the single layer structures 1 (related examples) shown in Table 1, three types of tunnel type magnetic sensors were selected among the laminated structures 1, each having a B concentration x of 20 atomic percent and a different average thickness (t1) of the CoFeB layer 4c1 or the like, and three types of tunnel type magnetic sensors were selected among the laminated structures 1, each having a B concentration x of 30 atomic percent and a different average thickness (t1) of the CoFeB layer 4c1 or the like. Subsequently, 80 tunnel type magnetic sensors of each type described above were manufactured, and the average of the RA, the average of the rate of change in resistance (ΔR/R), and the variations thereof were measured. In this experiment, the track width Tw and the height length of each sensor were set to 0.085 µm and 0.4 µm, respectively. In addition, the variations in properties were represented by (σ/Ave (%)). In this case, σ indicates the standard deviation, and Ave indicates the average of the RA and that of the rate of change in resistance (ΔR/R).

The experimental results are shown in Table 2 below.

**Table 2**

| | First fixed magnetic layer CoFe thickness (nm) | Second fixed magnetic layer | | | | Element properties | | | |
|---|---|---|---|---|---|---|---|---|---|
| | | CoFeB B concentration x(at.%) | CoFeB thickness t1 (nm) | CoFe thickness t2 (nm) | Total thickness (nm) | RA | | ΔR/R | |
| | | | | | | Ave (Ω·µm²) | σ/Ave (%) | Ave (%) | σ/Ave (%) |
| Single layer structure (related example | 1.4 | 16 | 1.8 | 0.0 | 1.8 | 4.23 | 7.6 | 27.1 | 9.0 |
| Laminated Structure (examples) | 1.4 | 20 | 1.5 | 0.3 | 1.8 | 3.79 | 7.2 | 26.9 | 8.6 |
| | 1.4 | 20 | 1.9 | 0.6 | 2.5 | 3.67 | 5.5 | 27.5 | 5.5 |
| | 2.1 | 20 | 2.4 | 0.6 | 3.0 | 3.70 | 5.3 | 27.7 | 5.2 |
| | 1.4 | 30 | 0.9 | 0.9 | 1.8 | 3.71 | 5.0 | 28.2 | 5.8 |
| | 2.1 | 30 | 1.4 | 1.1 | 2.5 | 3.59 | 4.0 | 29.1 | 3.9 |
| | 2.5 | 30 | 1.9 | 1.1 | 3.0 | 3.58 | 3.6 | 29.0 | 3.5 |

As shown in Table 2, it was found that compared to the single layer structure in which the second fixed magnetic layer 4c was formed of CoFeB_{16at%}, in the examples in which the second fixed magnetic layer 4c was formed of CoFeB and CoFe provided in that order from the bottom, the Ra (average value) could be decreased, and the rate of change in resistance (ΔR/R) (average value) could be increased, and that the variations in RA and rate of change in resistance (ΔR/R) could also be suppressed.

In addition, samples of the examples in which the second fixed magnetic layer 4c was formed of CoFeB_{20at%} and CoFe provided in that order from the bottom were further additionally formed as described below, and the RA and the rate of change in resistance (ΔR/R) were also measured.

The laminate T1 of the tunnel type magnetic sensor shown in Fig. 1 was formed by laminating the underlayer 1 of Ta (3); the seed layer 2 of (Ni_{0.8}Fe_{0.2})_{60at%}Cr_{40at%} (5); the antiferromagnetic layer 3 of IrMn (7); the fixed magnetic layer 4 composed of the first fixed magnetic layer 4a of Co_{70at%}Fe_{30at%} (1.4), the non-magnetic interlayer 4b of Ru (0.9), and the second fixed magnetic layer 4c (1.8); the insulating barrier layer 5 of Al-O; the free magnetic layer 6 composed of the enhancing layer 6a of Co_{50at%}Fe_{50at%} (1), and the soft magnetic layer 6b of Ni_{84at%}Fe_{16at%} (5); and the protective layer 7 of Ru(1)/Ta(28) in that order from the bottom. In addition, the value in the parentheses indicates the average thickness, and the unit thereof is nm.

After an Al layer having a thickness of 0.46 nm was formed, oxidation thereof was performed, so that the insulating barrier layer 5 was formed.

In addition, the surface of the second fixed magnetic layer 4c was processed by a plasma treatment before the insulating barrier layer 5 was formed.

In the experiment, as the second fixed magnetic layer 4c, the following structure was formed.

### (Single layer structure 2: related example)

A single layer structure of (Co_{0.75}Fe_{0.25})_{80at%}B_{20at%} (t1).

### (Laminated structure 3)

A laminated structure of (Co_{0.75}Fe_{0.25})_{80at%}B_{20at%} (t1)/Co_{90at%}Fe_{10at%} (t2) laminated in that order from the bottom.

### (Laminated structure 4)

A laminated structure of (Co_{0.75}Fe_{0.25})_{80at%}B_{20at%} (t1)/Co_{70at%}Fe_{30at%} (t2) laminated in that order from the bottom.

### (Laminated structure 5)

A laminated structure of (CO_{0.75}Fe_{0.25})_{80at%}B_{20at%} (t1)/Co_{50at%}Fe_{50at%} (t2) laminated in that order from the bottom.

### (Laminated structure 6)

A laminated structure of (Co_{0.75}Fe_{0.25})_{80at%}B_{20at%} (t1)/Co_{30at%}Fe_{70at%} (t2) laminated in that order from the bottom.

### (Laminated structure 7)

A laminated structure of (Co_{0.75}Fe_{0.25})_{80at%}B_{20at%} (t1)/Fe (t2) laminated in that order from the bottom.

### (Laminated structure 8)

A laminated structure of (Co_{0.75}Fe_{0.25})_{80at%}B_{20at%} (t1)/Co (t2) laminated in that order from the bottom.

### (Laminated structure 9; reference example)

A laminated structure of Co_{70at%}Fe_{30at%} (t2)/(Co_{0.75}Fe_{0.25})_{80at%}B_{20at%} (t1) laminated in that order from the bottom.

The values in the parentheses of the individual structures indicate the thicknesses, and the unit thereof is nm.

In the experiment, the RA and the rate of change in resistance (ΔR/R) of the tunnel type magnetic sensors having the above second fixed magnetic layers 4c were measured. The experimental results are shown in Table 3 below.
Table 3
(Co0.75Fe0.25)80B20 (t1 nm) single layer: single layer structure 2 (related example)
(Co0.75Fe0.25)80B20 (t1 nm)/Co90Fe10 (t2 nm) laminate: laminated structure 3
(Co0.75Fe0.25)80B20 (t1 nm)/Co70Fe30 (t2 nm) laminate: laminated structure 4
(Co0.75Fe0.25)80B20 (t1 nm)/Co50Fe50 (t2 nm) laminate: laminated structure 5
(Co0.75Fe0.25)80B20 (t1 nm)/Co30Fe70 (t2 nm) laminate: laminated structure 6
(Co0.75Fe0.25)80B20 (t1 nm)/Fe (t2 nm) laminate: laminated structure 7
(Co0.75Fe0.25)80B20 (t1 nm)/Co (t2 nm) laminate: laminated structure 8
Co70Fe30 (t2 nm)/(Co0.75Fe0.25)80B20 (t1 nm) laminate: laminated structure 9 (reference example)

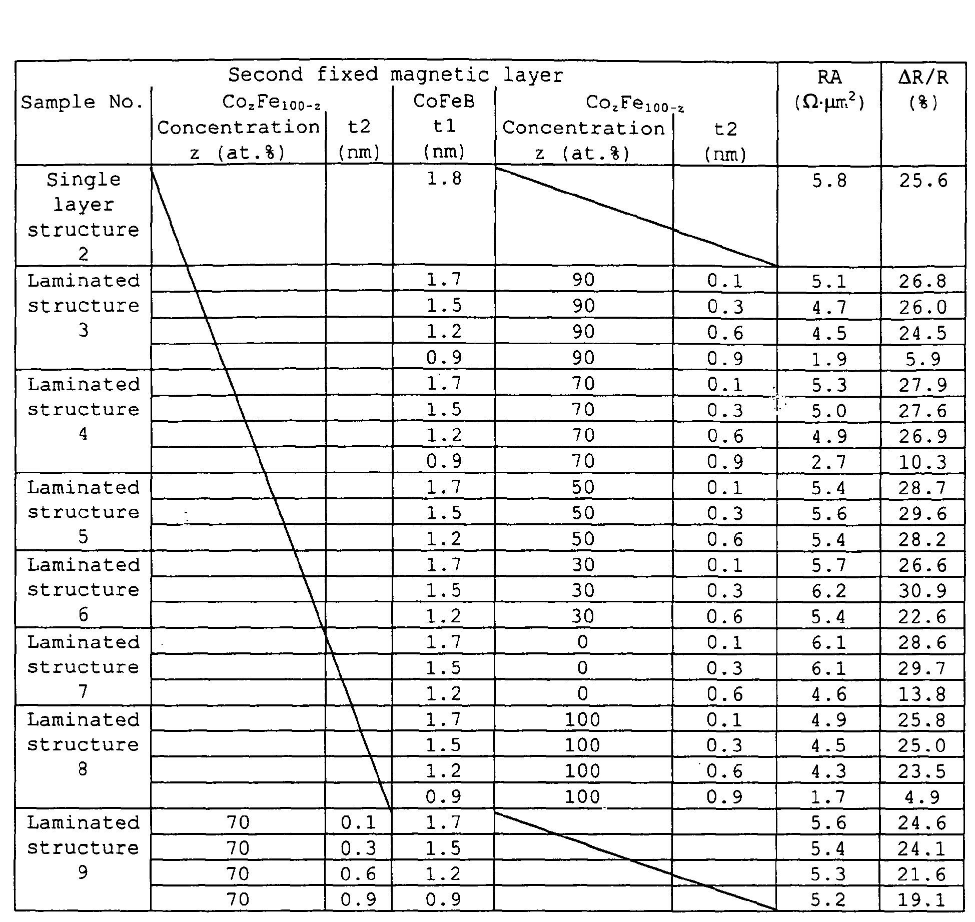

From the experimental results shown in Figs. 1 to 3, the second fixed magnetic layer 4c was formed by laminating the CoFeB layer 4c1 and the interface layer 4c2 of CoFe or Co in that order from the bottom, and in addition, the B concentration x was set in the range of more than 16 to 40 atomic percent. In addition, a more preferable B concentration x was set in the range of 17.5 to 35 atomic percent, and the most preferable B concentration x was set in the range of 20 to 30 atomic percent.

### (Experiment to define average thickness of CoFeB layer 4c1 and thickness ratio of interface layer 4c2 to CoFeB layer 4c1)

A substrate; the underlayer 1 of Ta (3); the seed layer 2 of (Ni_{0.8}Fe_{0.2})_{60at%}Cr_{40at%} (5); the antiferromagnetic layer 3 of IrMn (7); the fixed magnetic layer 4 composed of the first fixed magnetic layer 4a of Co_{70at%}Fe_{30at%} (1.4), the non-magnetic interlayer 4b of Ru (0.9), and the second fixed magnetic layer 4c of {(Co_{0.75}Fe_{0.25})_{80at%}B_{20at%} (t1)/Co₇₅ₐₜₘFe₂₅ₐₜₘ (t2)}; the insulating barrier layer 5 of Al-O; the free magnetic layer 6 composed of the enhancing layer 6a of Co_{50at%}Fe_{50at%} (1) and the soft magnetic layer 6b of Ni_{85at%}Fe_{15at%} (5); and the protective layer 7 of Ru(2)/Ta(27) were laminated to each other in that order from the bottom. In addition, the value in the parentheses indicates the average thickness, and the unit thereof is nm.

An Al layer having a thickness of 0.43 nm was formed, followed by oxidation thereof, so that the insulating barrier layer 5 was formed.

In addition, the surface of the second fixed magnetic layer 4c was processed by a plasma treatment before the insulating barrier layer 5 was formed. The above laminate was in the form of a solid film.

In the experiment, the average thickness t1 of (Co_{0.75}Fe_{0.25})_{80at%}B_{20at%} and the average thickness t2 of Co₇₅ₐₜₘFe₂₅ₐₜₘ, which formed the second fixed magnetic layer 4c, were changed, so that the relationship of the average thicknesses t1 and t2 with the Ra and the rate of change in resistance (ΔR/R) were investigated. The experimental results are shown in Tables 4 and 5 below.

**Table 4**

| RA(Ω·µm²) | | CoFe t2 (nm) | | | |
|---|---|---|---|---|---|
| | | 0.3 | 0.6 | 0.9 | 1.2 |
| CoFeB20 t1 (nm) | 1.1 | | 3.55 | 3.38 | 2.51 |
| | 1.5 | 3.78 | 3.61 | 3.83 | 3.51 |
| | 1.9 | 3.91 | 3.68 | 3.74 | 3.49 |
| | 2.3 | 3.91 | 3.75 | 3.72 | |

**Table 5**

| ΔR/R(%) | | CoFe t2 (nm) | | | |
|---|---|---|---|---|---|
| | | 0.3 | 0.6 | 0.9 | 1.2 |
| CoFeB20 t1 (nm) | 1.1 | | 24.4 | 22.9 | 16.8 |
| | 1.5 | 26.7 | 27.2 | 26.4 | 24.2 |
| | 1.9 | 27.6 | 27.8 | 28.1 | 25.2 |
| | 2.3 | 27.7 | 26.7 | 26.4 | |

When the average thicknesses t1 and t2 were selected from the range surrounded by thick frames in Tables 4 and 5, it was found that a low RA and a high rate of change in resistance (ΔR/R) could be simultaneously obtained.

From the average thicknesses t1 and t2 in the range surrounded by the thick frames in Tables 4 and 5, the thickness ratio (t2/t1) of the average thickness t2 of the interface layer 4c2 to the average thickness t1 of the CoFeB layer 4c1 was obtained. The results are shown in Table 6 below.

**Table 6**

| Ratio of CoFe thickness to CoFeB thickness | | CoFe t2 (nm) | | | |
|---|---|---|---|---|---|
| | | 0.3 | 0.6 | 0.9 | 1.2 |
| CoFeB20 t1 (nm) | 1.1 | | 0.5 | 0.8 | 1.1 |
| | 1.5 | 0.2 | 0.4 | 0.6 | 0.8 |
| | 1.9 | 0.2 | 0.3 | 0.5 | 0.6 |
| | 2.3 | 0.1 | 0.3 | 0.4 | |

Next, a substrate; the underlayer 1 of Ta (3); the seed layer 2 of (Ni_{0.8}Fe_{0.2})_{60at%}Cr_{40at%} (5); the antiferromagnetic layer 3 of IrMn (7); the fixed magnetic layer 4 composed of the first fixed magnetic layer 4a of Co_{70at%}Fe_{30at%} (1.4), the non-magnetic interlayer 4b of Ru (0.9), and the second fixed magnetic layer 4c of {(Co_{0.75}Fe_{0.25})_{70at%}B_{30at%} (t1)/Co₇₅ₐₜₘFe₂₅ₐₜₘ (t2)}; the insulating barrier layer 5 of Al-O; the free magnetic layer 6 composed of the enhancing layer 6a of Co_{50at%}Fe_{50at%} (1) and the soft magnetic layer 6b of Ni_{85at%}Fe_{15at%} (5); and the protective layer 7 of Ru(2)/Ta(27) were laminated to each other in that order from the bottom. In addition, the value in the parentheses indicates the average thickness, and the unit thereof is nm.

An Al layer having a thickness of 0.43 nm was formed, followed by oxidation thereof, so that the insulating barrier layer 5 was formed.

In addition, the surface of the second fixed magnetic layer 4c was processed by a plasma treatment before the insulating barrier layer 5 was formed. The above laminate was in the form of a solid film.

In the experiment, the average thickness t1 of (Co_{0.75}Fe_{0.25})_{70at%}B_{30at%} and the average thickness t2 of Co₇₅ₐₜₘFe₂₅ₐₜₘ, which formed the second fixed magnetic layer 4c, were changed, so that the relationship of the average thicknesses t1 and t2 with the Ra and the rate of change in resistance (ΔR/R) were investigated. The experimental results are shown in Tables 7 and 8 below.

**Table 7**

| RA(Ω·µm²) | | CoFe t2 (nm) | | | | |
|---|---|---|---|---|---|---|
| | | 0.3 | 0.6 | 0.9 | 1.2 | 1.5 |
| CoFeB30 t1 (nm) | 0.9 | | 3.25 | 3.09 | 3.05 | 2.96 |
| | 1.4 | 3.47 | 3.18 | 3.08 | 2.99 | 2.91 |
| | 1.9 | 3.49 | 3.16 | 2.95 | 2.95 | |
| | 2.3 | 3.51 | 3.14 | 2.98 | | |

**Table 8**

| ΔR/R(%) | | CoFe t2 (nm) | | | | |
|---|---|---|---|---|---|---|
| | | 0.3 | 0.6 | 0.9 | 1.2 | 1.5 |
| CoFeB30 t1 (nm) | 0.9 | | 25.7 | 28.2 | 28.0 | 26.3 |
| | 1.4 | 22.2 | 25.7 | 28.9 | 29.0 | 29.2 |
| | 1.9 | 21.4 | 26.2 | 27.7 | 29.1 | |
| | 2.3 | 20.7 | 24.9 | 27.1 | | |

When the average thicknesses t1 and t2 were selected from the range surrounded by thick frames in Tables 7 and 8, it was found that a low RA and a high rate of change in resistance (ΔR/R) could be simultaneously obtained. When the samples in the range surrounded by the thick frames in Tables 7 and 8 were compared, for example, with the single layer structure 1 in Table 1, it was found that compared to the single layer structure 1, the RA could be decreased, and the rate of change in resistance (ΔR/R) could also be increased.

From the average thicknesses t1 and t2 in the range surrounded by the thick frames in Tables 7 and 8, the thickness ratio (t2/t1) of the average thickness t2 of the interface layer 4c2 to the average thickness t1 of the CoFeB layer 4c1 was obtained. The results are shown in Table 9 below.

**Table 9**

| Ratio of CoFe thickness to cofeB thickness | | CoFe t2 (nm) | | | | |
|---|---|---|---|---|---|---|
| | | 0.3 | 0.6 | 0.9 | 1.2 | 1.5 |
| CoFeB30 t1 (nm) | 0.9 | | 0.7 | 1.0 | 1.3 | 1.7 |
| | 1.4 | 0.2 | 0.4 | 0.6 | 0.9 | 1.1 |
| | 1.9 | 0.2 | 0.3 | 0.5 | 0.6 | |
| | 2.3 | 0.1 | 0.3 | 0.4 | | |

In order to obtain a low RA and a high rate of change in resistance (ΔR/R), the following were found from Tables 4 to 9. That is, when the B concentration x of the CoFeB layer 4c1 was set to 20 atomic percent, it was found that from Tables 4 and 5, the average thickness t1 of the CoFeB layer 4c1 was preferably set to 1.5 nm or more. In addition, when the B concentration x of the CoFeB layer 4c1 was set to 30 atomic percent, it was found that from Tables 7 and 8, the average thickness t1 of the CoFeB layer 4c1 was preferably set to 0.9 nm or more.

In addition, when the B concentration x of the CoFeB layer 4c1 was set to 20 atomic percent, it was found that from Table 6, the thickness ratio (t2/t1) was preferably set in the range of 0.1 to 0.6. In addition, when the B concentration x of the CoFeB layer 4c1 was set to 30 atomic percent, it was found that from Table 9, the thickness ratio (t2/t1) was preferably set in the range of 0.5 to 1.3.

Fig. 8 is the graph showing the relationship between the B concentration x and the average thickness t1 of the CoFeB layer 4c1. The point (3) shown in Fig. 8 indicates a minimum necessary thickness (1.5 nm) of the CoFeB layer 4c1 when the B concentration x is set to 20 atomic percent, and the point (4) indicates a minimum necessary thickness (0.9 nm) of the CoFeB layer 4c1 when the B concentration x is set to 30 atomic percent. The point (1) shown in Fig. 8 indicates (B concentration x: average thickness t1 of the CoFeB layer 4c1)=(17.5 atomic percent: 1.65 nm), the point (2) shown in Fig. 8 indicates (B concentration x: average thickness t1 of the CoFeB layer 4c1)=(35 atomic percent: 0.60 nm), and the points (1) and (2) are obtained by extending the line that runs on the points (3) and (4).

Fig. 9 shows the relationship between the B concentration x and the thickness ratio (t2/t1) of the interface layer 4c2 to the CoFeB layer 4c1.

The point a shown in Fig. 9 indicates a minimum thickness ratio (t2/t1) (0.10) when the B concentration x is set to 20 atomic percent, and the point b indicates a minimum thickness ratio (t2/t1) (0.50) when the B concentration x is set to 30 atomic percent. In addition, the point c indicates a maximum thickness ratio (t2/t1) (1.30) when the B concentration x is set to 30 atomic percent, and the point d indicates a maximum thickness ratio (t2/t1) (0.60) when the B concentration x is set to 20 atomic percent.

The point A shown in Fig. 9 indicates (B concentration x: thickness ratio)=(17.5 atomic percent: 0.00), the point B indicates (B concentration x: thickness ratio)=(35 atomic percent: 0.70), the point C indicates (B concentration x: thickness ratio)=(35 atomic percent: 1.65), and the point D indicates (B concentration x: thickness ratio)=(17.5 atomic percent: 0.43). In addition, the points A and B are obtained by extending the line that runs on the points a and b, and the points C and D are obtained by extending the line that runs on the points c and d.

The B concentration x, the necessary average thickness (t1) of the CoFeB layer 4c1, and the minimum and the maximum thickness ratios (t2/t1) are shown in Table 10 below.

**Table 10**

| B concentration (at.%) | Necessary CoFeB thickness t1(nm) | Ratio of CoFe thickness to CoFeB thickness | |
|---|---|---|---|
| | | Minimum | Maximum |
| 17.5 | 1.65 | 0.00 (A) | 0.43 (D) |
| 20 | 1.50 | 0.10 (a) | 0.60 (d) |
| 30 | 0.90 | 0.50 (b) | 1.30 (c) |
| 35 | 0.60 | 0.70 (B) | 1.65 (C) |

As shown in Fig. 8, when the B concentration x is set in the range of 17.5 to 35 atomic percent, the average thickness t1 of the CoFeB layer 4c1 is set in the range of a line and thereabove in the graph (including the line) shown in Fig. 8, the line that runs on the points (1) and (2) in the graph.

In addition, as shown in Fig. 9, when the B concentration x is set in the range of 17.5 to 35 atomic percent, the thickness ratio (t2/t1) is set in the range surrounded by the line that runs on the points A and B (including the line, however, the point A is excluded), the line that runs on the points B and C (including the line, however), the line that runs on the points C and D (including the line), and the line that runs on the points D and A (including the line, however, the point A is excluded).

Accordingly, when the B concentration x is set in the range of 17.5 to 35 atomic percent, a low RA and a high rate of change in resistance (ΔR/R) can be effectively obtained at the same time.

In addition, when the B concentration x is set in the range of 20 to 30 atomic percent, the average thickness t1 of the CoFeB layer 4c1 is set in the range of a line and thereabove in the graph (including the line) shown in Fig. 8, the line that runs on the points (3) and (4) in the graph.

In addition, as shown in Fig. 9, when the B concentration x is set in the range of 20 to 30 atomic percent, the thickness ratio (t2/t1) is set in the range surrounded by the line that runs on the points a and b (including the line), the line that runs on the points b and c (including the line), the line that runs on the points c and d (including the line), and the line that runs on the points d and a (including the line).

Accordingly, when the B concentration x is set in the range of 20 to 30 atomic percent, a low RA and a high rate of change in resistance (ΔR/R) can be effectively obtained at the same time.

Next, a substrate; the underlayer 1 of Ta (3); the seed layer 2 of (Ni_{0.8}Fe_{0.2})_{60at%}Cr_{40at%} (5); the antiferromagnetic layer 3 of IrMn (7); the fixed magnetic layer 4 composed of the first fixed magnetic layer 4a of Co_{70at%}Fe30_{at%} (1.4), the non-magnetic interlayer 4b of Ru (0.9), and the second fixed magnetic layer 4c of {(Co_{0.75}Fe_{0.25}) _{100-xat%}B_{xat%} (t1)/Co₇₅ₐₜₘFe₂₅ₐₜₘ (t2)}; the insulating barrier layer 5 of Al-O; the free magnetic layer 6 composed of the enhancing layer 6a of Co_{50at%}Fe_{50at%} (1) and the soft magnetic layer 6b of Ni_{85at%}Fe_{15at%} (5); and the protective layer 7 of Ru(2)/Ta(27) were laminated to each other in that order from the bottom. In addition, the value in the parentheses indicates the average thickness, and the unit thereof is nm.

An A1 layer having a thickness of 0.43 nm was formed, followed by oxidation thereof, so that the insulating barrier layer 5 was formed.

In addition, the surface of the second fixed magnetic layer 4c was processed by a plasma treatment before the insulating barrier layer 5 was formed. The above laminate was in the form of a solid film.

In the experiment, the B concentration x was set in the range of 20 to 30 atomic percent, and in addition, as shown in Table 11 below, by adjusting the average thickness t1 of the CoFeB layer 4c1 and the average thickness t2 of the interface layer (CoFe) 4c2, the interlayer coupling magnetic field Hin of each sample was measured.

**Table 11**

| Second fixed magnetic layer | | | | | |
|---|---|---|---|---|---|
| CoFeB B concentration (at. %) | CoFeBx thickness t1 (nm) | CoFe thickness t2 (nm) | Total thickness (nm) | Hin (0e) | |
| 20 | 1.2 | 0.6 | 1.8 | 18.5 | (Reference example 1) |
| 20 | 1.5 | 0.6 | 2.1 | 15.8 | |
| 20 | 1.9 | 0.6 | 2.5 | 15.8 | |
| 20 | 2.3 | 0.6 | 2.9 | 16.4 | |
| 20 | 2.7 | 0.6 | 3.3 | 17.5 | |
| 30 | 0.4 | 1.1 | 1.5 | 13.1 | (Reference example 2) |
| 30 | 0.9 | 1.1 | 2.0 | 11.6 | |
| 30 | 1.4 | 1.1 | 2.5 | 11.9 | |
| 30 | 1.9 | 1.1 | 3.0 | 12.9 | |
| 30 | 2.3 | 1.1 | 3.4 | 13.7 | (Reference example 3) |

Samples of reference examples 1 and 2 shown in Table 11 were outside the necessary average thickness t1 of the CoFeB layer 4c1 shown in Fig. 8, and a sample of reference example 3 was outside the necessary thickness ratio shown in Table 10 and Fig. 9.

The interlayer coupling magnetic field Hin increases when the thickness of the second fixed magnetic layer is increased so as to increase the magnetization; however, as shown in Table 11, when the B concentration x was set to 20 atomic percent, the Hin was minimized when the average thickness t1 of the CoFeB layer was 1.5 nm, and when the B concentration x was set to 30 atomic percent, the Hin was minimized when the average thickness t1 of the CoFeB layer was 0.9 nm. From the results described above, it was found that when the B concentration x was set to 20 atomic percent, the flatness was most improved when the average thickness t1 of the CoFeB layer was 1.5 nm or more, and in addition, that when the B concentration x was set to 30 atomic percent, the flatness was most improved when the average thickness t1 of the CoFeB layer was 0.9 nm or more. The film quality of the insulating barrier layer 5, including the above-described flatness improvement effect, is improved, and hence it is thought that in this example, a low RA and a high rate of change in resistance (ΔR/R) can be simultaneously obtained.

In addition, as shown in Table 11, when the B concentration x was set to 30 atomic percent, the interlayer coupling magnetic field Hin was small as compared to that when the B concentration x was set to 20 atomic percent; hence, it is thought that when the B concentration x is increased, the CoFeB layer 4c1 is more likely to be placed in an amorphous state, and as a result, the flatness is more easily improved.

### (Experiment to define atomic ratio y of {Co_{y}Fe_{1-y}}₁₀₀₋ₓBₓ, and Co concentration z of Co_{z}Fe_{100-z} forming interface layer)

A substrate; the underlayer 1 of Ta (3); the seed layer 2 of (Ni_{0.8}Fe_{0.2})_{60at%}Cr_{40at%} (5); the antiferromagnetic layer 3 of IrMn (5.5); the fixed magnetic layer 4 composed of the first fixed magnetic layer 4a of Co_{70at%}Fe_{30at%} (2.1), the non-magnetic interlayer 4b of Ru (0.9), and the second fixed magnetic layer 4c of {(Co_{y}Fe_{1-y})_{80at%}B_{20at%} (1.9)/Co_{z}Fe_{100-z} (0.6)}; the insulating barrier layer 5 of A1-0; the free magnetic layer 6 composed of the enhancing layer 6a of Co_{20at%}Fe_{80at%} (1) and the soft magnetic layer 6b of Ni_{88at%}Fe_{12at%} (5) ; and the protective layer 7 of Ru(2)/Ta(27) were laminated to each other in that order from the bottom. In addition, the value in the parentheses indicates the average thickness, and the unit thereof is nm.

An Al layer having a thickness of 0.43 nm was formed, followed by oxidation thereof, so that the insulating barrier layer 5 was formed.

In addition, the surface of the second fixed magnetic layer 4c was processed by a plasma treatment before the insulating barrier layer 5 was formed.

In the experiment, as shown in Table 12 below, samples having different atomic ratios y of (Co_{y}Fe_{1-y})_{80at%}B_{20at%} forming the second fixed magnetic layer 4c and different Co concentrations z of Co_{z}Fe_{100-z} were manufactured, and the RA and the rate of change in resistance (ΔR/R) of each sample were measured. In the experiment, the Ra and the rate of change in resistance (ΔR/R) were measured using solid films. Subsequently, after laminates having the same film structures as described above were formed (however, oxidation time for the Al layer was different between the samples) separately from the above solid films and were then machined to form 80 tunnel type magnetic sensors shown in Fig. 1 for each sample, the average RA and the average rate of change in resistance (ΔR/R) were obtained from 80 tunnel type magnetic sensors (track width Tw: 0.085 µm, height length: 0.4 µm) of each sample, and in addition, the variations in RA and rate of change in resistance (ΔR/R) were also investigated (element properties). The experimental results are shown in Table 12 below.

**Table 12**

| Second fixed magnetic layer | | Film properties | | Element properties | | | |
|---|---|---|---|---|---|---|---|
| (Co_{y}Fe_{1-y})₈₀B₂₀ Atomic ratio | Co_{z}Fe_{100-z} Co concentration z | RA (Ω·µm²) | ΔR/R (%) | RA | | ΔR/R | |
| | | | | Ave. (Ω·µm²) | σ/Ave. (%) | Ave. (%) | σ/Ave. (%) |
| 0.9 | 90 | 2.6 | 24.7 | | | | |
| 0.9 | 70 | 3.0 | 29.3 | 3.9 | 5.9 | 30.8 | 7.1 |
| 0.9 | 50 | 3.4 | 31.9 | 3.7 | 7.1 | 29.9 | 9.5 |
| 0.7 | 90 | 2.7 | 28.7 | 3.9 | 5.6 | 32.0 | 6.3 |
| 0.7 | 70 | 3.1 | 31.0 | 4.0 | 6.1 | 32.7 | 7.0 |
| 0.7 | 50 | 3.4 | 32.9 | 3.9 | 6.0 | 32.3 | 7.7 |
| 0.5 | 90 | 2.8 | 29.4 | 3.9 | 5.6 | 32.5 | 7.1 |
| 0.5 | 70 | 3.1 | 30.2 | 3.9 | 6.4 | 31.8 | 8.5 |
| 0.5 | 50 | 3.6 | 31.1 | | | | |

As shown in Table 12, it was found that in the sample in which the atomic ratio y and the Co concentration z were set to 0.9 and 90 atomic percent, respectively, the rate of change in resistance (ΔR/R) as the film property decreased as compared to that of the other samples shown in Table 12.

In addition, as shown in Table 12, it was found that in the sample in which the atomic ratio y and the Co concentration z were set to 0.5 and 50 atomic percent, respectively, the RA as the film property increased as compared to that of the other samples shown in Table 12.

Accordingly, in order to simultaneously obtain a low RA and a high rate of change in resistance (ΔR/R), the above samples were excluded from the examples. The samples surrounded by a thick frame shown in Table 12 were the examples.

In addition, as shown in Table 12, it was found that in the sample in which the atomic ratio and the Co concentration z were set to 0.9 and 50 atomic percent, respectively, the variations in RA and rate of change in resistance (ΔR/R) as the element properties increased as compared to those of the other samples shown in Table 12.

Accordingly, when the variations were also taken into consideration, the sample described above was preferably excluded from the examples.

Next, a substrate; the underlayer 1 of Ta (3); the seed layer 2 of (Ni_{0.8}Fe_{0.2})_{60at%}Cr_{40at%} (5) ; the antiferromagnetic layer 3 of IrMn (5.5); the fixed magnetic layer 4 composed of the first fixed magnetic layer 4a of Co_{70at%}Fe_{30at%}(2.5), the non-magnetic interlayer 4b of Ru (0.9), and the second fixed magnetic layer 4c of {(CO_{y}Fe_{1-y})_{70at%}B_{30at%} (1.9) /Co_{z}Fe_{100-z} (1.1) }; the insulating barrier layer 5 of Al-O; the free magnetic layer 6 composed of the enhancing layer 6a of Co_{20at%}Fe_{80at%} (1) and the soft magnetic layer 6b of Ni_{88at%}Fe_{12at%} (5); and the protective layer 7 of Ru(2)/Ta(27) were laminated to each other in that order from the bottom. In addition, the value in the parentheses indicates the average thickness, and the unit thereof is nm.

An Al layer having a thickness of 0.43 nm was formed, followed by oxidation thereof, so that the insulating barrier layer 5 was formed.

In addition, the surface of the second fixed magnetic layer 4c was processed by a plasma treatment before the insulating barrier layer 5 was formed.

In the experiment, as shown in Table 13 below, samples having different atomic ratios y of (Co_{y}Fe_{1-y})_{70at%}B_{30at%} forming the second fixed magnetic layer 4c and different Co concentrations z of Co_{z}Fe_{100-z} were manufactured, and the RA and the rate of change in resistance (ΔR/R) of each sample were measured. In the experiment, the Ra and the rate of change in resistance (ΔR/R) were measured using solid films. Subsequently, after laminates having the same film structures as described above were formed (however, oxidation time for the Al layer was different between the samples) separately from the above solid films and were then machined to form 80 tunnel type magnetic sensors shown in Fig. 1 for each sample, the average RA and the average rate of change in resistance (ΔR/R) were obtained from 80 tunnel type magnetic sensors (track width Tw: 0.08 µm, height length: 0.4 µm) of each sample, and in addition, the variations in RA and rate of change in resistance (ΔR/R) were also investigated (element properties). The experimental results are shown in Table 13 below.

**Table 13**

| Second fixed magnetic layer | | Film properties | | Element properties | | | |
|---|---|---|---|---|---|---|---|
| (Co_{y}Fe_{1-y})₇₀B₃₀ Atomic ratio | Co_{z}Fe_{100-z} Co concentration z | RA (Ω.µm²) | ΔR/R (%) | RA | | ΔR/R | |
| | | | | Ave. (Ω·µm²) | σ/Ave. (%) | Ave. (%) | σ/Ave. (%) |
| 0.9 | 90 | 2.7 | 26.2 | | | | |
| 0.9 | 70 | 3.1 | 31.6 | 4.2 | 6.1 | 32.4 | 7.4 |
| 0.9 | 50 | 3.6 | 33.2 | 4.1 | 8.2 | 31.4 | 10.6 |
| 0.7 | 90 | 2.7 | 28.4 | 4.0 | 4.4 | 31.2 | 6.1 |
| 0.7 | 70 | 3.3 | 31.9 | 4.0 | 6.3 | 32.2 | 7.9 |
| 0.7 | 50 | 3.7 | 33.9 | 4.1 | 7.5 | 31.4 | 9.5 |
| 0.5 | 90 | 2.7 | 28.6 | 4.1 | 5.0 | 32.0 | 5.8 |
| 0.5 | 70 | 3.2 | 32.8 | 4.3 | 5.1 | 33.3 | 6.6 |
| 0.5 | 50 | 3.5 | 32.0 | 4.2 | 5.9 | 32.5 | 7.6 |
| 0.2 | 90 | 3.0 | 30.8 | 4.1 | 5.6 | 32.2 | 5.8 |
| 0.2 | 70 | 3.4 | 32.1 | 4.1 | 5.8 | 33.2 | 6.4 |
| 0.2 | 50 | 3.8 | 32.2 | | | | |
| 0.2 | 20 | 3.7 | 22.6 | | | | |

As shown in Table 13, it was found that in the sample in which the atomic ratio y and the Co concentration z were set to 0.9 and 90 atomic percent, respectively, and in the sample in which the atomic ratio y and the Co concentration z were set to 0.2 and 20 atomic percent, respectively, the rate of change in resistance (ΔR/R) as the film property decreased as compared to that of the other samples.

In addition, as shown in Table 13, it was found that in the sample in which the atomic ratio y and the Co concentration z were set to 0.2 and 50 atomic percent, respectively, the RA as the film property increased as compared to that of the other samples.

Accordingly, in order to obtain a low RA and a high rate of change in resistance (ΔR/R), the above three samples were excluded from the examples. The samples surrounded by a thick frame shown in Table 13 were the examples.

In addition, as shown in Table 13, it was found that in the sample in which the atomic ratio y and the Co concentration z were set to 0.9 and 50 atomic percent, respectively, and in the sample in which the atomic ratio y and the Co concentration z were set to 0.7 and 50 atomic percent, respectively, the variations in RA and rate of change in resistance (ΔR/R) as the element properties increased as compared to those of the other samples.

Accordingly, when the variations were also taken into consideration, the above two sample were preferably excluded from the examples.

Fig. 10 is a three-dimensional graph in which an X axis indicates the atomic ratio y, a Y axis indicates the Co concentration z, and a Z axis indicates the B concentration x. The points shown in Fig. 10 are measurement points shown in Tables 12 and 13.

In Fig. 10, point e indicates (atomic ratio y: Co concentration z: B concentration x)=(0.5: 50 atomic percent: 30 atomic percent), point f indicates (atomic ratio y: Co concentration z: B concentration x)=(0.20: 70 atomic percent: 30 atomic percent), point g indicates (atomic ratio y: Co concentration z: B concentration x)=(0.20: 90 atomic percent: 30 atomic percent), point h indicates (atomic ratio y: Co concentration z: B concentration x)=(0.7: 90 atomic percent: 30 atomic percent), point i indicates (atomic ratio y: Co concentration z: B concentration x)=(0.9: 70 atomic percent: 30 atomic percent), point j indicates (atomic ratio y: Co concentration z: B concentration x)=(0.9: 50 atomic percent: 30 atomic percent), point k indicates (atomic ratio y: Co concentration z: B concentration x)=(0.70: 50 atomic percent: 20 atomic percent), point 1 indicates (atomic ratio y: Co concentration z: B concentration x)=(0.50: 70 atomic percent: 20 atomic percent), point m indicates (atomic ratio y: Co concentration z: B concentration x)=(0.5: 90 atomic percent: 20 atomic percent), point n indicates (atomic ratio y: Co concentration z: B concentration x)=(0.7: 90 atomic percent: 20 atomic percent), point o indicates (atomic ratio y: Co concentration z: B concentration x)=(0.9: 70 atomic percent: 20 atomic percent), and point p indicates (atomic ratio y: Co concentration z: B concentration x)=(0.9: 50 atomic percent: 20 atomic percent).

In Fig. 10, point E indicates (atomic ratio y: Co concentration z: B concentration x)=(0.4: 50 atomic percent: 35 atomic percent), point K indicates (atomic ratio y: Co concentration z: B concentration x)=(0.75: 50 atomic percent: 17.5 atomic percent), and the points E and K are obtained by extending a line that runs on the points e and k.

In Fig. 10, point F indicates (atomic ratio y: Co concentration z: B concentration x)=(0.05: 70 atomic percent: 35 atomic percent), point L indicates (atomic ratio y: Co concentration z: B concentration x)=(0.58: 70 atomic percent: 17.5 atomic percent), and the points F and L are obtained by extending a line that runs on the points f and 1.

In Fig. 10, point G indicates (atomic ratio y: Co concentration z: B concentration x)=(0.05: 90 atomic percent: 35 atomic percent), point M indicates (atomic ratio y: Co concentration z: B concentration x)=(0.58: 90 atomic percent: 17.5 atomic percent), and the points G and M are obtained by extending a line that runs on the points g and m.

In Fig. 10, point H indicates (atomic ratio y: Co concentration z: B concentration x)=(0.7: 90 atomic percent: 35 atomic percent), point N indicates (atomic ratio y: Co concentration z: B concentration x)=(0.7: 90 atomic percent: 17.5 atomic percent), and the points H and N are obtained by extending a line that runs on the points h and n.

In Fig. -10, point I indicates (atomic ratio y: Co concentration z: B concentration x)=(0.9: 70 atomic percent: 35 atomic percent), point O indicates (atomic ratio y: Co concentration z: B concentration x)=(0.9: 70 atomic percent: 17.5 atomic percent), and the points I and O are obtained by extending a line that runs on the points i and o.

In Fig. 10, point J indicates (atomic ratio y: Co concentration z: B concentration x)=(0.9: 50 atomic percent: 35 atomic percent), point P indicates (atomic ratio y: Co concentration z: B concentration x)=(0.9: 50 atomic percent: 17.5 atomic percent), and the points J and P are obtained by extending a line that runs on the points j and p.

The relationship of the points E to P and e to p with the B concentration x, the atomic percent y, and the Co concentration z are shown in Table 14.

**Table 14**

| B concentration | Second fixed magnetic layer | | | |
|---|---|---|---|---|
| | (Co_{y} Fe_{1-y})B y | Co_{z} Fe_{100-z} z (at. %) | | |
| x (at. %) | | 50 | 70 | 90 |
| 17.5 | 0.58 | | L | M |
| | 0.70 | | | N |
| | 0.75 | K | | |
| | 0.90 | P | 0 | |
| 20 | 0.50 | | 1 | m |
| | 0.70 | k | | n |
| | 0.90 | p | o | |
| 30 | 0.20 | | f | g |
| | 0.50 | e | | |
| | 0.70 | | | h |
| | 0.90 | j | i | |
| 35 | 0.05 | | F | G |
| | 0.40 | E | | |
| | 0.70 | | | H |
| | 0.90 | J | I | |

In addition, when the B concentration x is set in the range 17.5 to 35 atomic percent, the atomic ratio y and the Co concentration z are defined within a polyhedron in the three-dimensional graph shown in Fig. 10 surrounded by:
a line (including the line) that runs on the points E and F, a line (including the line) that runs on the points F and G, a line (including the line) that runs on the points G and H, a line (including the line) that runs on the points H and I, a line (including the line) that runs on the points I and J, and a line (including the line) that runs on the points J and E;
a line (including the line) that runs on points K and L, a line (including the line) that runs on the points L and M, a line (including the line) that runs on the points M and N, a line (including the line) that runs on the points N and O, a line (including the line) that runs on the points O and P, and a line (including the line) that runs on the points P and K; and
a line (including the line) that runs on the points E and K, a line (including the line) that runs on the points F and L, a line (including the line) that runs on the points G and M, a line (including the line) that runs on the points H and N, a line (including the line) that runs on the points I and O, and a line (including the line) that runs on the points J and P. Accordingly, a low RA and a high rate of change in resistance (ΔR/R) can be effectively obtained at the same time.

In addition, it is preferable that the points E and I be connected by a line (including the line) and that the points K and O be connected by a line (including the line). That is, when the B concentration x is set in the range of 17.5 to 35 atomic percent, the atomic ratio y and the Co concentration z are more preferably defined within a polyhedron in the three-dimensional graph shown in Fig. 10 surrounded by:
the line (including the line) that runs on the points E and I, the line (including the line) that runs on the points E and F, the line (including the line) that runs on the points F and G, the line (including the line) that runs on the points G and H, and the line (including the line) that runs on the points H and I;
the line (including the line) that runs on the points K and O, the line (including the line) that runs on the points K and L, the line (including the line) that runs on the points L and M, the line (including the line) that runs on the points M and N, and the line (including the line) that runs on the points N and O; and
the line (including the line) that runs on the points E and K, the line (including the line) that runs on the points F and L, the line (including the line) that runs on the points G and M, the line (including the line) that runs on the points H and N, and the line (including the line) that runs on the points I and O. Accordingly, the variations in RA and rate of change in resistance (ΔR/R) can be effectively suppressed.

In addition, when the B concentration x is in the range of 20 to 30 atomic percent, the atomic ratio y and the Co concentration z were defined in a polyhedron surrounded by a line (including the line) that runs on the points e and f, a line (including the line) that runs on the points f and g, a line (including the line) that runs on the points g and h, a line (including the line) that runs on the points h and i, a line (including the line) that runs on the points i and j, and a line (including the line) that runs on the points j and e;
a line (including the line) that runs on the points k and 1, a line (including the line) that runs on the points 1 and m, a line (including the line) that runs on the points m and n, a line (including the line) that runs on the points n and o, a line (including the line) that runs on the points o and p, and a line (including the line) that runs on the points p and k; and
a line (including the line) that runs on the points e and K, a line (including the line) that runs on the points f and 1, a line (including the line) that runs on the points g and m, a line (including the line) that runs on the points h and n, a line (including the line) that runs on the points i and o, and a line (including the line) that runs on the points j and p. Accordingly, a low RA and a high rate of change in resistance (ΔR/R) can be effectively obtained at the same time.

In addition, it is preferable that the point e and the point i be connected by a line (including the line), and the point k and the point o be connected by a line (including the line). That is, when the B concentration x is in the range of 20 to 30 atomic percent, the atomic ratio y of the CoFeB layer 4c1 and the Co concentration z of the interface layer 4c2 formed of Co_{z}Fe_{100-z} are more preferably defined within a polyhedron shown in the three-dimensional graph in Fig. 10 surrounded by:
the line that runs on the points e and i (including the line), the line that runs on the points e and f (including the line), the line that runs on the points f and g (including the line), the line that runs on the points g and h (including the line), and the line that runs on the points h and i (including the line);
the line that runs on the points k and o (including the line), the line that runs on the points k and 1 (including the line), the line that runs on the points 1 and m (including the line), the line that runs on the points m and n (including the line), and the line that runs on the points n and o (including the line); and
the line that runs on the points e and k (including the line), the line that runs on the points f and 1 (including the line), the line that runs on the points g and m (including the line), the line that runs on the points h and n (including the line), and the line that runs on the points i and o (including the line). Accordingly, the variations in properties, such as the RA and the rate of change in resistance (ΔR/R), can be effectively suppressed.

## Claims

1. A tunnel type magnetic sensor comprising: a lamination portion including a fixed magnetic layer that has a fixed magnetization direction; an insulating barrier layer; and a free magnetic layer that has a variable magnetization direction with respect to an external magnetic field, wherein the fixed magnetic layer, the insulating barrier layer and the free magnetic layer are laminated to each other in that order from the bottom,
wherein the insulating barrier layer is formed of Al-O, and
a barrier layer-side magnetic layer that forms at least a part of the fixed magnetic layer and that is in contact with the insulating barrier layer is formed to have a CoFeB region formed of CoFeB and an intervening region that is located between the CoFeB region and the insulating barrier layer and that is formed of CoFe or Co.

2. The tunnel type magnetic sensor according to Claim 1, wherein the CoFeB region has a composition gradient region that has a gradual decreasing gradient in a B concentration from an opposite side opposite to a boundary with the intervening region toward the intervening region.

3. A tunnel type magnetic sensor comprising: a lamination portion including a fixed magnetic layer that has a fixed magnetization direction; an insulating barrier layer; and a free magnetic layer that has a variable magnetization direction with respect to an external magnetic field, wherein the fixed magnetic layer, the insulating barrier layer and the free magnetic layer are laminated to each other in that order from the bottom,
wherein the insulating barrier layer is formed of Al-O,
a barrier layer-side magnetic layer that forms at least a part of the fixed magnetic layer and that is in contact with the insulating barrier layer is formed of CoFeB, and
in the barrier layer side magnetic layer, a B concentration at an interface side in contact with the insulating barrier layer is lower than that at an opposite side opposite to the interface.

4. The tunnel type magnetic sensor according to Claim 3, wherein the barrier layer-side magnetic layer has a composition gradient region in which the B concentration gradually decreases from the opposite side toward the interface side.

5. The tunnel type magnetic sensor according to any of Claims 1 to 4, wherein the barrier layer-side magnetic layer is formed by element diffusion that occurs at an interface between a CoFeB layer formed of CoFeB and an intervening layer that is located between the CoFeB layer and the insulating barrier layer and that is formed of CoFe or Co, the CoFeB layer and the intervening layer being laminated to each other to form a lamination structure.

6. A tunnel type magnetic sensor comprising: a lamination portion including a fixed magnetic layer that has a fixed magnetization direction; an insulating barrier layer; and a free magnetic layer that has a variable magnetization direction with respect to an external magnetic field,
the fixed magnetic layer, the insulating barrier layer and the free magnetic layer are laminated to each other in that order from the bottom,
wherein the insulating barrier layer is formed of Al-O, and
a barrier layer-side magnetic layer that forms at least a part of the fixed magnetic layer and that is in contact with the insulating barrier layer is formed to have a lamination structure including a CoFeB layer formed of CoFeB and an intervening layer that is located between the CoFeB layer and the insulating barrier layer and that is formed of CoFe or Co.

7. The tunnel type magnetic sensor according to Claim 5 or 6, wherein the CoFeB layer is formed of {Co_{y}Fe_{1-y}}₁₀₀₋ₓBₓ (where y indicates an atomic ratio), and a B concentration x is in the range of more than 16 to 40 atomic percent.

8. The tunnel type magnetic sensor according to Claim 7, wherein the B concentration x is in the range of 17.5 to 35 atomic percent.

9. The tunnel type magnetic sensor according to Claim 7 or 8, wherein the average thickness of the CoFeB layer is in the range of a line (including the line) and thereabove in a graph shown in Fig. 8, the line that runs on point (1) (B concentration x: average thickness of the CoFeB layer)=(17.5 atomic percent: 1.65 nm) and on point (2) (B concentration x: average thickness of the CoFeB layer)=(35 atomic percent: 0.60 nm), and in a graph shown in Fig. 9, the thickness ratio of the interface layer to the CoFeB layer (average thickness of the interface layer/average thickness of the CoFeB layer) is in the range surrounded by a line that runs on point A (B concentration x: thickness ratio)=(17.5 atomic percent: 0.00) and on point B (B concentration x: thickness ratio)=(35 atomic percent: 0.70) (including the line, however the point A is excluded), a line that runs on the point B and point C (B concentration x: thickness ratio)=(35 atomic percent: 1.65) (including the line), a line that runs on the point C and on point D (B concentration x: thickness ratio)=(17.5 atomic percent: 0.43) (including the line), and a line that runs on the point D and on the point A (including the line, however the point A is excluded).

10. The tunnel type magnetic sensor according to any of Claims 7 to 9, wherein the intervening layer is formed of CO_{z}Fe_{100·z}, and the atomic ratio y of the CoFeB layer and a Co concentration z of the intervening layer are defined within a polyhedron in a three-dimensional graph shown in Fig. 10 surrounded by:
a line (including the line) that runs on point E (atomic ratio y: Co concentration z: B concentration x)=(0.4: 50 atomic percent: 35 atomic percent) and on point F (atomic ratio y: Co concentration z: B concentration x)=(0.05: 70 atomic percent: 35 atomic percent), a line (including the line) that runs on the point F and on point G (atomic ratio y: Co concentration z: B concentration x)=(0.05: 90 atomic percent: 35 atomic percent), a line (including the line) that runs on the point G and on point H (atomic ratio y: Co concentration z: B concentration x)=(0.7: 90 atomic percent: 35 atomic percent), a line (including the line) that runs on the point H and on point I (atomic ratio y: Co concentration z: B concentration x)=(0.9: 70 atomic percent: 35 atomic percent), a line (including the line) that runs on the point I and on point J (atomic ratio y: Co concentration z: B concentration x)=(0.9: 50 atomic percent: 35 atomic percent), and a line (including the line) that runs on the point J and on the point E;
a line (including the line) that runs on point K (atomic ratio y: Co concentration z: B concentration x)=(0.75: 50 atomic percent: 17.5 atomic percent) and on point L (atomic ratio y: Co concentration z: B concentration x)=(0.58: 70 atomic percent: 17.5 atomic percent), a line (including the line) that runs on the point L and on point M (atomic ratio y: Co concentration z: B concentration x)=(0.58: 90 atomic percent: 17.5 atomic percent), a line (including the line) that runs on the point M and on point N (atomic ratio y: Co concentration z: B concentration x)=(0.7: 90 atomic percent: 17.5 atomic percent), a line (including the line) that runs on the point N and on point O (atomic ratio y: Co concentration z: B concentration x)=(0.9: 70 atomic percent: 17.5 atomic percent), a line (including the line) that runs on the point O and on point P (atomic ratio y: Co concentration z: B concentration x)=(0.9: 50 atomic percent: 17.5 atomic percent), and a line (including the line) that runs on the point P and the point K; and
a line (including the line) that runs on the point E and on the point K, a line (including the line) that runs on the point F and on the point L, a line (including the line) that runs on the point G and on the point M, a line (including the line) that runs on the point H and on the point N, a line (including the line) that runs on the point I and on the point O, and a line (including the line) that runs on the point J and the point P.

11. The tunnel type magnetic sensor according to any of Claims 7 to 10, wherein the B concentration x is in the range of 20 to 30 atomic percent.

12. The tunnel type magnetic sensor according to Claim 11, wherein the average thickness of the CoFeB layer is in the range of a line (including the line) and thereabove in a graph shown in Fig. 8, the line that runs on point (3) (B concentration x: average thickness of the CoFeB layer)=(20 atomic percent: 1.5 nm) and on point (4) (B concentration x: average thickness of the CoFeB layer)=(30 atomic percent: 0.90 nm), and in a graph shown in Fig. 9, the thickness ratio of the interface layer to the CoFeB layer (average thickness of the interface layer/average thickness of the CoFeB layer) is in the range surrounded by a line (including the line) that runs on point a (B concentration x: thickness ratio)=(20.0 atomic percent: 0.10) and on point b (B concentration x: thickness ratio)=(30 atomic percent: 0.50), a line (including the line) that runs on the point b and on point c (B concentration x: thickness ratio)=(30 atomic percent: 1.30), a line (including the line) that runs on the point c and on point d (B concentration x: thickness ratio)=(20 atomic percent: 0.60), and a line (including the line) that runs on the point d and on the point a.

13. The tunnel type magnetic sensor according to Claim 11 or 12, wherein the intervening layer is formed of Co_{z}Fe_{100-z}' and the atomic ratio y of the CoFeB layer and a Co concentration z of the intervening layer are defined within a polyhedron in a three-dimensional graph shown in Fig. 10 surrounded by:
a line (including the line) that runs on point e (atomic ratio y: Co concentration z: B concentration x)=(0.5: 50 atomic percent: 30 atomic percent) and on point f (atomic ratio y: Co concentration z: B concentration x)=(0.20: 70 atomic percent: 30 atomic percent), a line (including the line) that runs on the point f and on point g (atomic ratio y: Co concentration z: B concentration x)=(0.20: 90 atomic percent: 30 atomic percent), a line (including the line) that runs on the point g and on point h (atomic ratio y: Co concentration z: B concentration x)=(0.7: 90 atomic percent: 30 atomic percent), a line (including the line) that runs on the point h and on point i (atomic ratio y: Co concentration z: B concentration x)=(0.9: 70 atomic percent: 30 atomic percent), a line (including the line) that runs on the point i and on point j (atomic ratio y: Co concentration z: B concentration x)=(0.9: 50 atomic percent: 30 atomic percent), and a line (including the line) that runs on the point j and on the point e;
a line (including the line) that runs on point k (atomic ratio y: Co concentration z: B concentration x)=(0.70: 50 atomic percent: 20 atomic percent) and on point 1 (atomic ratio y: Co concentration z: B concentration x)=(0.50: 70 atomic percent: 20 atomic percent), a line (including the line) that runs on the point 1 and on point m (atomic ratio y: Co concentration z: B concentration x)=(0.50: 90 atomic percent: 20 atomic percent), a line (including the line) that runs on the point m and on point n (atomic ratio y: Co concentration z: B concentration x)=(0.7: 90 atomic percent: 20 atomic percent), a line (including the line) that runs on the point n and on point o (atomic ratio y: Co concentration z: B concentration x)=(0.9: 70 atomic percent: 20 atomic percent), a line (including the line) that runs on the point o and on point p (atomic ratio y: Co concentration z: B concentration x)=(0.9: 50 atomic percent: 20 atomic percent), and a line (including the line) that runs on the point p and on the point k; and
a line (including the line) that runs on the point e and on the point K, a line (including the line) that runs on the point f and on the point 1, a line (including the line) that runs on the point g and on the point m, a line (including the line) that runs on the point h and on the point n, a line (including the line) that runs on the point i and on the point o, and a line (including the line) that runs on the point j and on the point p.

14. The tunnel type magnetic sensor according to any of Claims 1 to 13, wherein the fixed magnetic layer has a laminated ferrimagnetic structure formed of a first fixed magnetic layer, a second fixed magnetic layer, and a non-magnetic interlayer provided therebetween, and the second fixed magnetic layer is the barrier layer-side magnetic layer in contact with the insulating barrier layer.

15. A method for manufacturing a tunnel type magnetic sensor having a lamination portion including a fixed magnetic layer that has a fixed magnetization direction, an insulating barrier layer, and a free magnetic layer that has a variable magnetization direction with respect to an external magnetic field, the fixed magnetic layer, the insulating layer and the free magnetic layer are laminated to each other in that order from the bottom, the method comprising:
a step (a) of laminating an interface layer composed of CoFe or Co on a CoFeB layer composed of CoFeB to form a barrier layer-side magnetic layer which forms at least a part of the fixed magnetic layer;
a step (b) of forming the insulating barrier layer composed of Al-O on the barrier layer-side magnetic layer; and
a step (c) of forming the free magnetic layer on the insulating barrier layer.

16. The method for manufacturing a tunnel type magnetic sensor, according to Claim 15, wherein the CoFeB layer is formed of {Co_{y}Fe_{1-y}}₁₀₀₋ₓBₓ (where y indicates an atomic ratio), and a B concentration x is formed in the range of more than 16 to 40 atomic percent.

17. The method for manufacturing a tunnel type magnetic sensor, according to Claim 16, wherein the B concentration x is formed in the range of 17.5 to 35 atomic percent.

18. The method for manufacturing a tunnel type magnetic sensor, according to Claim 16 or 17, wherein the average thickness of the CoFeB layer is formed in the range of a line (including the line) and thereabove in a graph shown in Fig. 8, the line that runs on point (1) (B concentration x: average thickness of the CoFeB layer)=(17.5 atomic percent: 1.65 nm) and on point (2) (B concentration x: average thickness of the CoFeB layer)=(35 atomic percent: 0.60 nm), and in a graph shown in Fig. 9, the thickness ratio of the interface layer to the CoFeB layer (average thickness of the interface layer/average thickness of the CoFeB layer) is adjusted in the range surrounded by a line that runs on point A (B concentration x: thickness ratio)=(17.5 atomic percent: 0.00) and on point B (B concentration x: thickness ratio)=(35 atomic percent: 0.70) (including the line, however the point A is excluded), a line that runs on the point B and on point C (B concentration x: thickness ratio)=(35 atomic percent: 1.65) (including the line), a line that runs on the point C and on point D (B concentration x: thickness ratio)=(17.5 atomic percent: 0.43) (including the line), and a line that runs on the point D and on the point A (including the line, however the point A is excluded).

19. The method for manufacturing a tunnel type magnetic sensor, according to any of Claims 16 to 18, wherein the intervening layer is formed of Co_{z}Fe_{100-z}, and the atomic ratio y of the CoFeB layer and a Co concentration z of the interface layer are adjusted within a polyhedron in a three-dimensional graph shown in Fig. 10 surrounded by:
a line (including the line) that runs on point E (atomic ratio y: Co concentration z: B concentration x)=(0.4: 50 atomic percent: 35 atomic percent) and on point F (atomic ratio y: Co concentration z: B concentration x)=(0.05: 70 atomic percent: 35 atomic percent), a line (including the line) that runs on the point F and on point G (atomic ratio y: Co concentration z: B concentration x)=(0.05: 90 atomic percent: 35 atomic percent), a line (including the line) that runs on the point G and on point H (atomic ratio y: Co concentration z: B concentration x)=(0.7: 90 atomic percent: 35 atomic percent), a line (including the line) that runs on the point H and on point I (atomic ratio y: Co concentration z: B concentration x)=(0.9: 70 atomic percent: 35 atomic percent), a line (including the line) that runs on the point I and on point J (atomic ratio y: Co concentration z: B concentration x)=(0.9: 50 atomic percent: 35 atomic percent), and a line (including the line) that runs on the point J and on the point E;
a line (including the line) that runs on point K (atomic ratio y: Co concentration z: B concentration x)=(0.75: 50 atomic percent: 17.5 atomic percent) and on point L (atomic ratio y: Co concentration z: B concentration x)=(0.58: 70 atomic percent: 17.5 atomic percent), a line (including the line) that runs on the point L and on point M (atomic ratio y: Co concentration z: B concentration x)=(0.58: 90 atomic percent: 17.5 atomic percent), a line (including the line) that runs on the point M and on point N (atomic ratio y: Co concentration z: B concentration x)=(0.7: 90 atomic percent: 17.5 atomic percent), a line (including the line) that runs on the point N and on point O (atomic ratio y: Co concentration z: B concentration x)=(0.9: 70 atomic percent: 17.5 atomic percent), a line (including the line) that runs on the point O and on point P (atomic ratio y: Co concentration z: B concentration x)=(0.9: 50 atomic percent: 17.5 atomic percent), and a line (including the line) that runs on the point P and on the point K; and
a line (including the line) that runs on the point E and on the point K, a line (including the line) that runs on the point F and on the point L, a line (including the line) that runs on the point G and on the point M, a line (including the line) that runs on the point H and on the point N, a line (including the line) that runs on the point I and on the point O, and a line (including the line) that runs on the point J and on the point P.

20. The method for manufacturing a tunnel type magnetic sensor, according to any of Claims 16 to 19, wherein the B concentration x is formed in the range of 20 to 30 atomic percent.

21. The method for manufacturing a tunnel type magnetic sensor, according to Claim 20, wherein the average thickness of the CoFeB layer is formed on the range of a line (including the line) and thereabove in a graph shown in Fig. 8, the line that runs on point (3) (B concentration x: average thickness of the CoFeB layer)=(20 atomic percent: 1.5 nm) and on point (4) (B concentration x: average thickness of the CoFeB layer)=(30 atomic percent: 0.90 nm), and in a graph shown in Fig. 9, the thickness ratio of the interface layer to the CoFeB layer (average thickness of the interface layer/average thickness of the CoFeB layer) is adjusted in the range surrounded by a line (including the line) that runs on point a (B concentration x: thickness ratio)=(20.0 atomic percent: 0.10) and on point b (B concentration x: thickness ratio)=(30 atomic percent: 0.50), a line (including the line) that runs on the point b and on point c (B concentration x: thickness ratio)=(30 atomic percent: 1.30), a line (including the line) that runs on the point c and on point d (B concentration x: thickness ratio)=(20 atomic percent: 0.60), and a line (including the line) that runs on the point d and on the point a.

22. The method for manufacturing a tunnel type magnetic sensor, according to Claim 20 or 21, wherein the intervening layer is formed of Co_{z}Fe_{100-z}, and the atomic ratio y of the CoFeB layer and a Co concentration z of the interface layer are adjusted within a polyhedron in a three-dimensional graph shown in Fig. 10 surrounded by:
a line (including the line) that runs on point e (atomic ratio y: Co concentration z: B concentration x)=(0.5: 50 atomic percent: 30 atomic percent) and on point f (atomic ratio y: Co concentration z: B concentration x)=(0.20: 70 atomic percent: 30 atomic percent), a line (including the line) that runs on the point f and on point g (atomic ratio y: Co concentration z: B concentration x)=(0.20: 90 atomic percent: 30 atomic percent), a line (including the line) that runs on the point g and on point h (atomic ratio y: Co concentration z: B concentration x)=(0.7: 90 atomic percent: 30 atomic percent), a line (including the line) that runs on the point h and on point i (atomic ratio y: Co concentration z: B concentration x)=(0.9: 70 atomic percent: 30 atomic percent), a line (including the line) that runs on the point i and on point j (atomic ratio y: Co concentration z: B concentration x)=(0.9: 50 atomic percent: 30 atomic percent), and a line (including the line) that runs on the point j and on the point e;
a line (including the line) that runs on point k (atomic ratio y: Co concentration z: B concentration x)=(0.70: 50 atomic percent: 20 atomic percent) and on point 1 (atomic ratio y: Co concentration z: B concentration x)=(0.50: 70 atomic percent: 20 atomic percent), a line (including the line) that runs on the point 1 and on point m (atomic ratio y: Co concentration z: B concentration x)=(0.50: 90 atomic percent: 20 atomic percent), a line (including the line) that runs on the point m and on point n (atomic ratio y: Co concentration z: B concentration x)=(0.7: 90 atomic percent: 20 atomic percent), a line (including the line) that runs on the point n and on point o (atomic ratio y: Co concentration z: B concentration x)=(0.9: 70 atomic percent: 20 atomic percent), a line (including the line) that runs on the point o and on point p (atomic ratio y: Co concentration z: B concentration x)=(0.9: 50 atomic percent: 20 atomic percent), and a line (including the line) that runs on the point p and on the point k; and
a line (including the line) that runs on the point e and on the point K, a line (including the line) that runs on the point f and on the point 1, a line (including the line) that runs on the point g and the point m, a line (including the line) that runs on the point h and on the point n, a line (including the line) that runs on the point i and on the point o, and a line (including the line) that runs on the point j and the point p.

23. The method for manufacturing a tunnel type magnetic sensor, according to any of Claims 15 to 22, wherein, when the insulating barrier layer is formed, an Al layer is formed, and the Al layer is then oxidized to form the insulating barrier layer composed of Al-O.

24. The method for manufacturing a tunnel type magnetic sensor, according to any of Claims 15 to 23, wherein, when the insulating barrier layer is formed, the insulating barrier layer composed of Al-O is directly formed using an Al-O target on the barrier layer-side magnetic layer.

25. The method for manufacturing a tunnel type magnetic sensor, according to any of Claims 15 to 24, wherein, after the lamination portion is formed, an annealing treatment is performed.
